# EUROPEAN PATENT APPLICATION

(11) **EP 0 566 306 A2**
(43) Date of publication of application: **20.10.1993**
(21) Application number: 93302693.2
(22) Date of filing: 06.04.1993
(51) Int. Cl.: G11C 11/00, G11C 14/00

(54) **Semiconductor memory device**

(30) Priority: 16.04.1992 JP 122568/92
(71) Applicant: HITACHI, LTD., Chiyoda-ku, Tokyo 100 (JP)
(72) Inventor: Ishihara, Masamichi, Hamura-shi, Tokyo (JP); Satou, Hiroshi, Ohme-shi, Tokyo (JP); Kotani, Hiroaki, Ohme-shi, Tokyo (JP); Yoshida, Keiichi, Ohme-shi, Tokyo (JP)
(74) Representative: Calderbank, Thomas Roger

(57) **Abstract**

A semiconductor memory device constructed by packaging a nonvolatile memory chip capable of being electrically written and erased and a RAM into a common package.

## Description

The present invention relates to a semiconductor memory device and, more particularly, to a technology which is effective if applied to a semiconductor memory device capable of making stored data nonvolatile and accessing the data at a high speed.

The nonvolatile is exemplified by a Flash memory for carrying out an erasing operation by making use of a tunnel current. This Flash memory is disclosed on pp. 1157 to 1163 of IEEE JOURNAL OF SOLID-STATE CIRCUITS, Vol. 23, No. 5, Oct., 1988.

The aforementioned nonvolatile memory is featured by the fact that the data are not lost even if the power supply is disconnected. However, the nonvolatile memory is defective in its slow writing and reading operations and in a limit to the number of its rewriting times. Therefore, we have conceived to provide a semiconductor memory device which is enabled to achieve a high-speed access while eliminating the limit to the rewriting number and to make the data nonvolatile even for the disconnection of the power supply by packaging the nonvolatile memory in a package common to a volatile memory (which will be shortly called the "RAM") of high-speed access.

An object of the present invention is to provide an excellent usable, novel semiconductor memory device.

The aforementioned and other objects and novel features of the present invention will become apparent from the description to be made with reference to the accompanying drawings.

The representatives of the invention to be disclosed herein will be briefly summarized in the following. Specifically, one semiconductor memory device is constructed by packaging a nonvolatile memory chip capable of being electrically written and erased and a RAM chip in a common package.

According to the means described above, the memory access can be accelerated without any limit to the rewriting number by performing it upon the RAM, and the data can be made nonvolatile by writing the data of the RAM in the nonvolatile memory before the power supply is disconnected.

In the drawings:
Fig. 1 is a block diagram showing one embodiment of a semiconductor memory device according to the present invention and a microcomputer system using the former;
Fig. 2 is a flow chart illustrating one embodiment for explaining the data transfer operation from a dynamic RAM to a batch-erasing type nonvolatile memory:
Fig. 3 is a flow chart illustrating one embodiment for explaining the data transfer operation from the batch-erasing type nonvolatile memory to the dynamic RAM;
Fig. 4 is a timing chart illustrating one embodiment of the data transfer operation from the dynamic RAM to the batch-erasing type nonvolatile memory:
Fig. 5 is a timing chart illustrating one embodiment of the data transfer operation from the batch-erasing type nonvolatile memory to the dynamic RAM;
Fig. 6 is a block diagram showing the inside of one embodiment of the batch-erasing type nonvolatile memory;
Fig. 7 is a block diagram showing a semiconductor memory device of another embodiment according to the present invention and a microcomputer system using the former;
Fig. 8 is a block diagram showing the inside of one embodiment of the dynamic RAM;
Fig. 9 is a flow chart showing one embodiment for explaining the data transfer operation from the batch-erasing type nonvolatile memory to the dynamic RAM;
Fig. 10 is a flow chart showing one embodiment for explaining the data transfer operation from the dynamic RAM to the batch-erasing type nonvolatile memory;
Fig. 11 is a timing chart illustrating one example of the transfer operation from the batch-erasing type nonvolatile memory to the dynamic RAM;
Fig. 12 is a timing chart illustrating one example of the transfer operation from the dynamic RAM to the batch-erasing type nonvolatile memory;
Fig. 13 is a block diagram showing the inside of another embodiment of the batch-erasing type nonvolatile memory;
Fig. 14 is a block diagram showing a semiconductor memory device of another embodiment according to the present invention and a microcomputer system using the former;
Fig. 15 is a diagram illustrating the pin arrangement of one embodiment of the dynamic RAM;
Fig. 16 is a section showing one embodiment of the semiconductor memory device according to the present invention;
Fig. 17 is a top plan view showing a portion inside of one embodiment of the semiconductor memory device according to the present invention;
Fig. 18 is a top plan view showing a portion of the memory cell of the dynamic RAM and a section showing the corresponding portion;
Fig. 19 is a top plan view showing a portion of the memory cell of the batch-erasing type nonvolatile memory and a section showing the corresponding portion;
Fig. 20 is a circuit diagram showing one embodiment of the memory array of the dynamic RAM and the X-Address selector;
Fig. 21 is a circuit diagram showing one embodiment of the memory mat MAT of the batch-erasing type nonvolatile memory and its major peripheral circuits; and
Fig. 22 is a block diagram showing one embodiment of a power supply method of the microcomputer system using the semiconductor memory device according to the present invention.

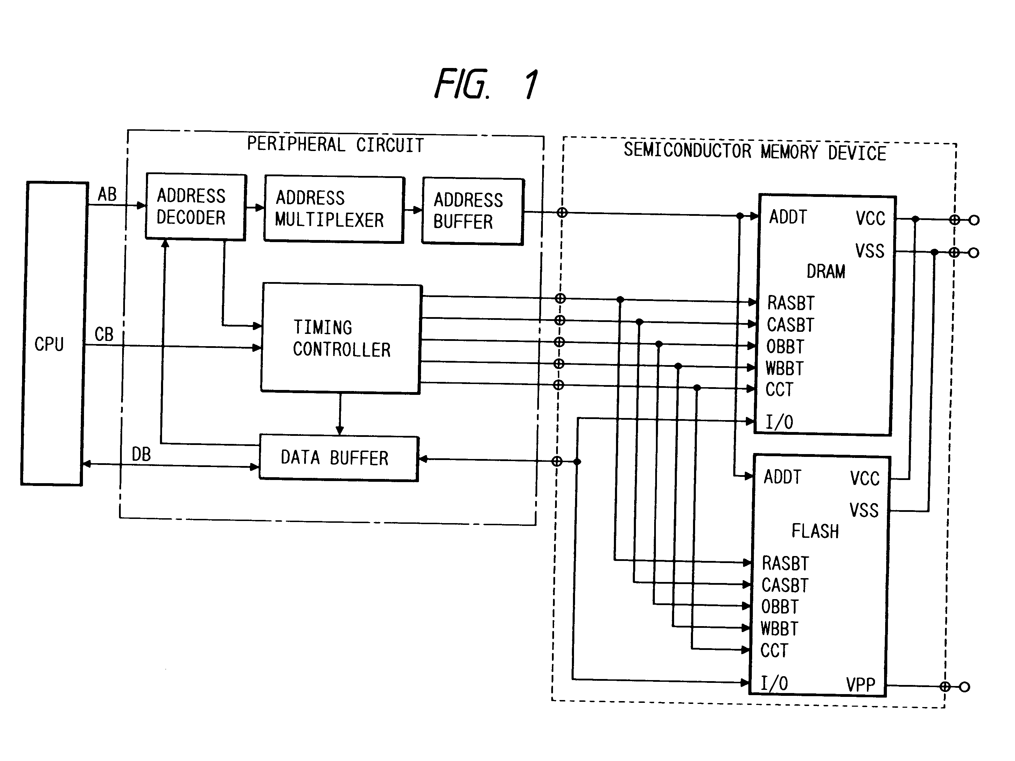

Fig. 1 is a block diagram showing one embodiment of a semiconductor memory device according to the present invention and a microcomputer system using the former.

The semiconductor memory device of this embodiment is constructed by packaging two memory chips in one package, as indicated by broken lines in Fig. 1. One memory chip is of the dynamic RAM (which will be shortly referred to as the "DRAM"), and the other memory chip is a batch-erased type nonvolatile memory (as will be shortly referred to as the "FLASH" or "Flash"). These two memory chips DRAM and FLASH are made to have an equal storage capacity (or an equal number of memory cells), although not especially limited thereto. As a result, the two memories DRAM and FLASH are equipped with address terminals ADDT of an equal number of bits, which are shared in the package and connected with a common external address terminal.

The memory chip DRAM is equipped like the well-known dynamic RAM with a terminal RASB to be fed with a row address strobe signal RASB, a terminal CASBT to be fed with a column address strobe signal CASB, a terminal WEBT to be fed with a write enable signal WEB, and a terminal OEBT to be fed with an output enable signal OEB as its control terminals. The memory chip FLASH of this embodiment is caused unlike the aforementioned well-known flash memory to fetch address signals by the address multiplex method in addition to the dynamic RAM. Like the memory chip DRAM, therefore, the memory chip FLASH is equipped with the row address strobe terminal RASBT, the column address strobe terminal CASBT, the write enable terminal WEBT and the output enable terminal OEBT.

The corresponding ones of these control terminals are made common in the package and connected with the external control terminals. According to the construction described above, there arises a disadvantage that the two memory chips are simultaneously accessed. Therefore, the memory chips DRAM and FLASH are newly equipped with control terminals CCT to be fed with a control signal CC for separating the DRAM mode and the FLASH mode. If the mode selecting signal CC to be fed to the control terminal CCT is set to a low level, for example, the memory chip FLASH has its all terminals brought into the high-impedance state and into the DRAM mode in which the memory chip DRAM is subjected to a memory access. If, on the other hand, the mode selecting signal CC is set to a high level, the memory chip DRAM has all terminals brought into the high-impedance state and into the FLASH mode in which the memory chip FLASH is subjected to the memory access. In this FLASH mode, the memory chip DRAM comes into a self-refresh mode, in which it is automatically self- refreshed by an automatic refresh circuit disposed inside, to latch the data inbetween.

The power supply terminals such as a power supply voltage terminal VCC at about 5 V or the like and an earth potential VSS of the circuit are made common and connected with the external power supply terminals. On the other hand, the memory chip FLASH is equipped with a high voltage terminal VPP at about 12 V or the like necessary for its writing and erasing operations. The high voltage terminal VPP is used the power supply terminals especially for the memory chip FLASH.

Although not especially limitative, the VPP power supply terminal can be omitted if a FLASH memory chip used is of single power supply type of 5 V, but the chip has to package therein a boosterfor boosting the supply voltage of 5 V to a high voltage of about 12 V. On the other hand, the voltage VCC is at about 3.3 V if the DRAM and FLASH capable of being used in the line of 3.3 V are used.

The microcomputer system of Fig. 1 is constructed to include the semiconductor memory device described above, and a peripheral circuit and a central processing unit (as will be shortly called the "CPU") for selecting the semiconductor memory device. The program ROM, the disc memory unit, the input device such as the keyboard, and the output device such as the display or printer are omitted because they have no direct relation to the present invention, although they are indispensable in the microcomputer system.

An address signal ADD produced by the CPU is fed through an address bus AB to the address decoder. This address decoder feeds the address signal to the address multiplexer, if it decodes the address signal as an address assigned to the aforementioned semiconductor memory device. The address multiplexer classifies the address into an X-address and a Y-address and sends out them in a time sharing manner in synchronism with the address strobe signals RASB and CASB which are produced in the later-described timing controller. The address buffer the X-address signal and the Y-address signal thus produced in a time sharing manner to the semiconductor memory device according to the present invention.

A control signal produced by the CPU is fed via a control bus CB to the timing controller. This timing controller receives both the control signal for controlling the writing/reading operations of the memory and the output timing signal of the X- and Y- address signals produced by the aforementioned address decoder, to produce and feed the aforementioned address strobe signals RASB and CASB, output enable signal OEB, write enable signal WEB and chip control signal CC to the semiconductor memory device according to the present invention.

The data buffer is a bidirectional buffer which is connected with a data bus DB of the CPU to transfer the write data and the read data and has its data transfer direction instructed by the timing controller. Although not especially limitative, the signal to be transmitted from the data buffer to the address decoder is used for extending the address. Specifically, the extended address is outputted from the data bus of the CPU and is latched in the data buffer until it is transmitted as the extended address to the address decoder.

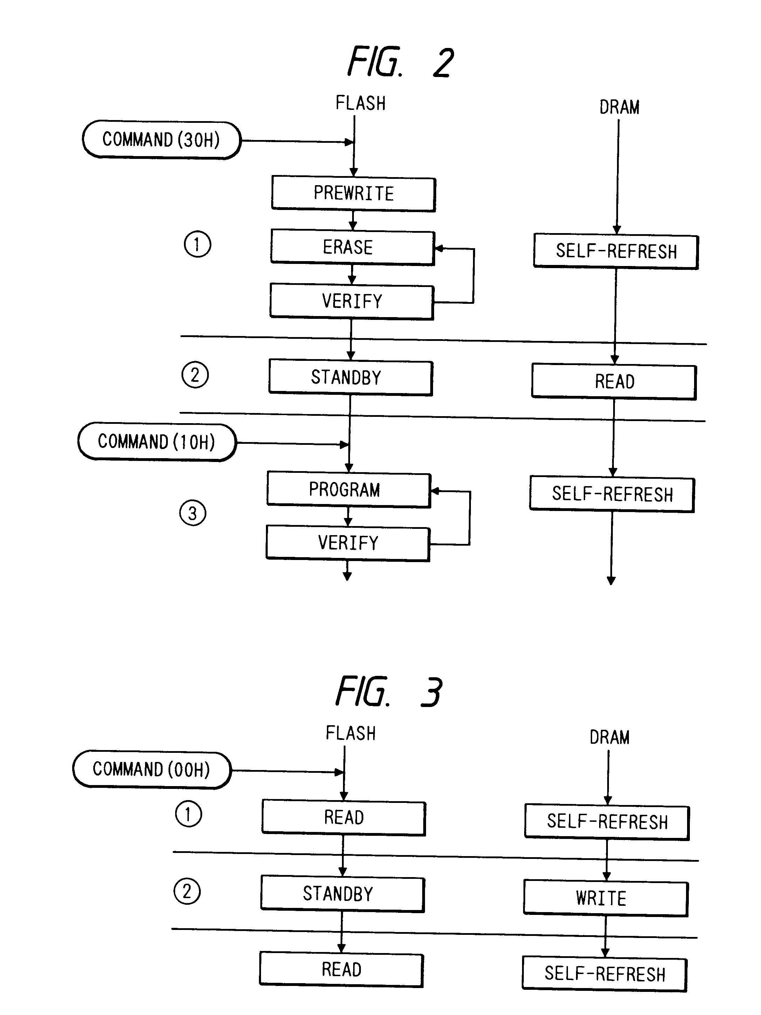

Fig. 2 is a flow chart showing one embodiment for explaining the data transfer from the DRAM to the Flash.

At the CPU instructs the Flash the erasing operation. Specifically, the CPU raises the chip control signal CC to the high level to activate the Flash, and this Flash receives a command 30H from a data input/output terminal I/O through the data bus DB. In this meanwhile, the DRAM has its all external terminals brought to the high-impedance state in response to the high level of the signal CC and comes into the self-refresh mode.

The Flash decodes the aforementioned command 30H and executes the prewrite on the basis of the decode prior to the actual erasing operation. The stored data in the memory cell before erased, i.e., the threshold voltage of the memory element has a variety of high and low levels according to the presence of the writing operation. The aforementioned prewrite operation is to write all the memory elements prior to the electric erasing operation so that some of the unwritten memory cells, i.e., the erased memory cells may be prevented from taking a negative threshold voltage by the following automatic erasing operation.

In the electric erasure, generally speaking, the threshold voltage after erasure of long time may take a negative value unlike the threshold voltage in the thermal equilibrium state. This is contrary to the case of the erasure with ultraviolet rays as in the EPROM (i.e., Erasable Programmable Read Only Memory), in which the threshold voltage is set to that when the memory device is fabricated so that it can be controlled by the manufacture method. The aforementioned memory cell has its reading operation adversely affected if the threshold value becomes negative. In this prewrite operation, all the target bits are written in a batch.

When the prewrite described above is ended, the following erasure (or erasing operation) is executed. An erasing pulse is issued forthe batch erasure. After this, a verifying operation is executed in accordance with the aforementioned address setting. In this verifying operation, the operating voltage is switched for the reading operation to a voltage as low as 3.5 V lower than the low voltage VCC. In this reading operation, it is decided that the erasing state having the threshold voltage no more than the aforementioned value of 3.5 V has come, if the reading signal is at "0", and the address incrementations are sequentially executed.

It is decided as in the aforementioned prewriting operation whether or not the address is final. If NOT, a verifying operation similar to the aforementioned is executed. The erasing operation is ended by repeating the verifications till the final address. Since this erasing operation is of the batch type, as described above, the number of erasures is determined by that of the memory cells in the chip, which has its threshold voltage raised to the maximum by the writing operations. Specifically, the erasing pulses are produced on the basis of the result of verifications till the memory cell having its threshold voltage maximized takes a readable, i.e., low threshold voltage such as the aforementioned value of about 3.5 V. Thanks to these controlled erasing operations, the threshold voltage of the memory cells can be accurately set not to a negative value but to a predetermined voltage.

After the end of the aforementioned erasing operations, the CPU switches at ② the chip control signal CC from the high to low levels to bring the Flash to a standby state and to activate the DRAM into a read mode. In other words, the stored data are read from the leading address of the DRAM.

In response to the read data from the DRAM, the CPU switches at ③ the chip control signal CC to the high level and inputs not only a command 10H through the data bus DB to the Flash to instruct it the writing operation but also the read data from the aforementioned DRAM as its write data. As a result, the Flash executes the writing operation. At this time, in order to stabilize the excessive write level, after one write pulse is produced as in the erasing operation, the verification is executed to produce the aforementioned write pulse till the read signal reaches "1", i.e., till the threshold voltage exceeds 5 V. In this meanwhile, the DRAM is held in the self-refresh mode in response to the high level of the aforementioned signal CC.

The operations ② and ③ described above are executed for all the stored data of the DRAM to transfer the stored data of the DRAM to the Flash. After this, if the power supply of the microcomputer system including the semiconductor memory device of this embodiment is disconnected, the data stored in the DRAM are broken, but the same data can be stored in the Flash.

Fig. 3 is a flow chart showing one embodiment for explaining the data transferring operation from the Flash to the DRAM.

If the power supply is made again, the CPU raises at ① the chip control signal CC to the high level to activate the Flash and inputs a command OOH through the data bus DB. Alternatively, the Flash may be automatically brought into the read mode in dependence upon the level of the control signal OEB or WEB although the commands for instructing that lead mode are not inputted one by one. In this meanwhile, the DRAM has its all external terminals brought into the high-impedance state in response to the high level of the signal CC and executes the self-refresh mode, but these operations should be understood as dummy operations for meaningless data.

The Flash decodes the aforementioned command OOH to execute the reading operations on the basis of the decoded command. In response to the read data, the CPU drops at ② the chip control signal CC to the low level and brings the DRAM into the write mode to write the aforementioned read data at the corresponding addresses. In this meanwhile, the Flash is held in the standby state by the low level of the signal CC.

From now on, the operations ① and ② are executed to the final addresses of the Flash and the DRAM, thus ending the aforementioned data transferring operation. Thanks to this data transferring operation, the data before disconnection of the power supply can be stored in the DRAM so that the microcomputer system can restore the same state as that before the power supply disconnection.

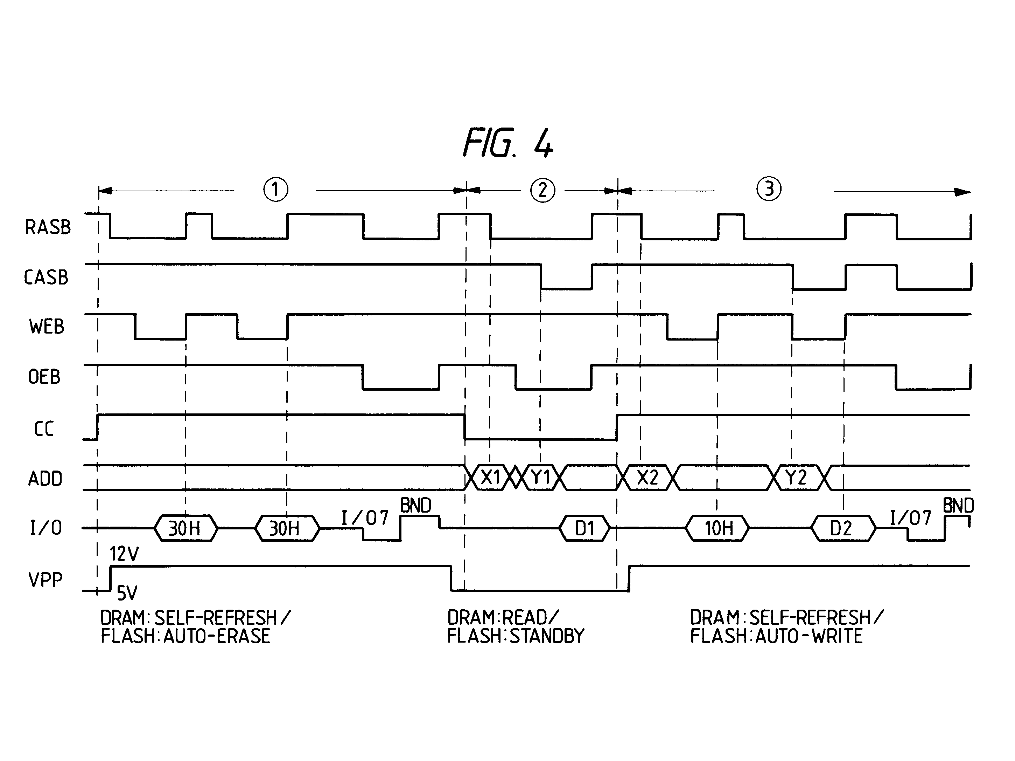

Fig. 4 is a timing chart showing one embodiment for explaining the data transferring operation from the DRAM to the Flash.

For the time period the chip control signal CC is raised to the high level by the CPU to instruct the Flash mode. At this time, a chip is selected in response to the low level of the signal RASB to fetch the command 30H inputted to a data input/output terminal I/O, at a changing timing from the low to high levels of the signal WEB. In order to prevent any malfunction, the Flash of this embodiment comes into the erasing mode while awaiting two consecutive inputs of the command 30H instructing the aforementioned erasing operation. Incidentally, in case there are installed on the system a plurality of semiconductor memory devices having the aforementioned DRAM and Flash combined therein, the aforementioned signal RASB instructs what of the semiconductor memory devices is to be accessed. In this case, the aforementioned chip control signal CC is commonly fed to the plurality of semiconductor memory devices.

The erasing operation is started in response to the low level of the signal RASB and the signal OEB. In this meanwhile, the data input/output terminal I/O is held in the high-impedance state, and the data input/output terminal 1/07 to be fed with the most significant bit is used for data polling. Specifically, the data input/output terminal 1/07 sends out its output signal at the low level during the erasing operation and is changed to the high level at the end of the erasing operation. The CPU monitors the low level of the aforementioned data input/output terminal 1/07 by the data polling to decide the end of the erasing operation in view of the change of the same to the high level.

During the time period ②, the CPU drops the chip control signal CC to the low level to instruct the DRAM mode. At this time, as in the operation of the ordinary dynamic RAM, the X-line row address signal X1 is fetched and latched in response to the low level of the row address strobe signal RASB so that the selecting operation of the X-line is executed. Next, in response to the low level of the column address strobe signal CASB, the Y-line column address signal Y1 is fetched to instruct the reading mode in response to the high level of the signal WEB so that the aforementioned data D1 are read out from the DRAM.

During the time period ③, the CPU raises the chip control signal CC to the high level to instruct the Flash mode again. At this time, in response to the low level of the signal RASB, a chip is selected to fetch the X-line row address signal X2. At the changing timing from the low to high levels of the signal WEB, the command 10H inputted to the data input/output terminal I/O is fetched. As a result, the Flash is instructed the writing mode. Next, the Y-line column address signal Y2 is fetched in response to the low level of the signal CASB so that the memory cell selecting operation is executed. In synchronism with the change of the signal WEB from the low to high levels, the write data D2 corresponding to the aforementioned data D1 are fetched into the Flash.

Although not especially limitative, in response to the low level of the signals RASB, CASB and OEB, the automatic writing operation is started. In this meanwhile, the data input/output terminal 1/07 sends out the output signal at the low level during the time period of the writing operation and is changed to the high level at t he end of t he writing operation. The CPU monitors the low level of the aforementioned data input/output terminal 1/07 by the data polling to decide the end of the writing operation in response to the change of the same signal to the high level. From now on, the routine returns to ②, at which a next address is read outfrom the DRAM, and then transfers to ③, at which the data read out from the aforementioned DRAM are written in the Flash, and these operations are repeated. In this embodiment, the high voltage VPP is switched as between 12 V / 5 V in response to the high/low level of the aforementioned chip control signal CC.

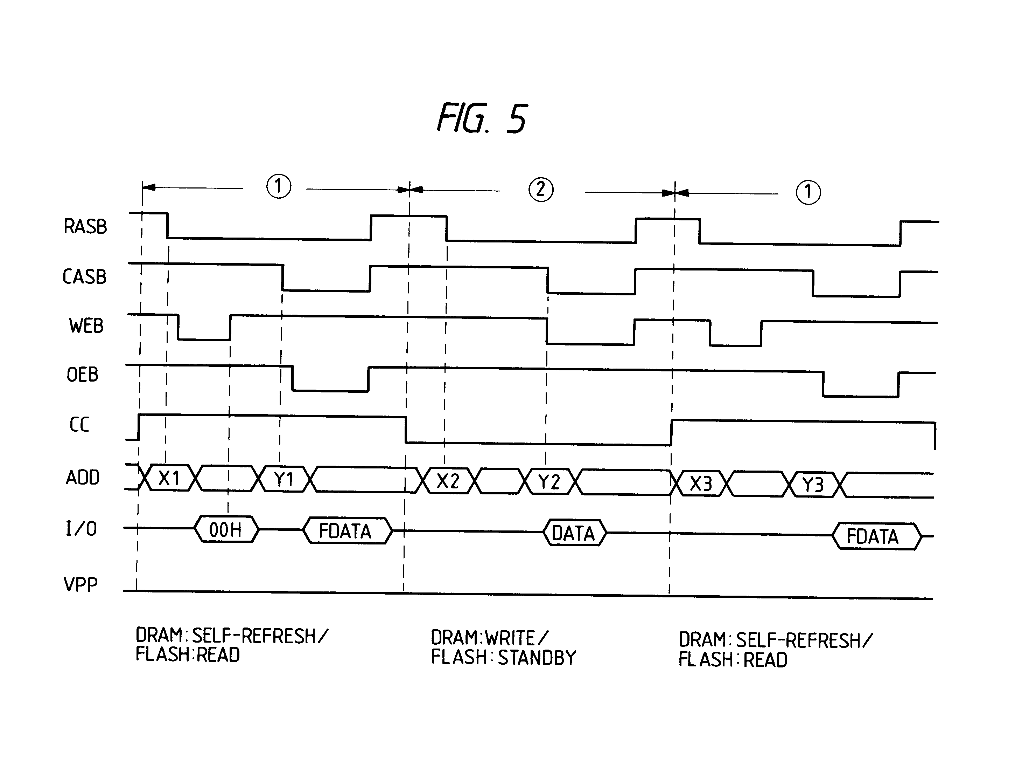

Fig. 5 is a timing chart showing one embodiment for explaining the data transferring operations from the Flash to the DRAM.

During the time period ①, the CPU raises the chip control signal CC to the high level to instruct the Flash mode. At this time, a chip is selected in response to the low level of the signal RASB to fetch the X-line row address signal X1 inputted in synchronism with it. At the changing timing of the signal WEB from the low to high levels, the command OOH inputted to the data terminal I/O is fetched. In the Flash of this embodiment, the command OOH instructing the reading mode is used, but this reading mode may be automatically effected even if no command is inputted. Next, the Y-line column address signal Y1 inputted in synchronism with the low level of the signal CASB is fetched, and the stored data FDATA of the Flash memory selected in response to those address signals X1 and Y1 are outputted.

During the time period ②, the CPU drops the chip control signal CC to the low level to instruct the DRAM mode. At this time, as in the operation of the ordinary dynamic RAM, the X-line row address signal X2 is fetched and latched in response to the low level of the row address strobe signal RASB so that the selecting operation of the X-line is executed. Next, in response to the low level of the column address strobe signal CASB, the Y-line column address signal Y2 is fetched to instruct the write mode in response to the low level of the signal WEB, so that the data FDATA read from the aforementioned Flash are written as the write data DATA of the DRAM in the selected memory cell.

From now on, like the time period next addresses X3 and Y3 are read from the DRAM, and the writing operations is executed like the time period ② in the write mode of the DRAM. These operations are repeated.

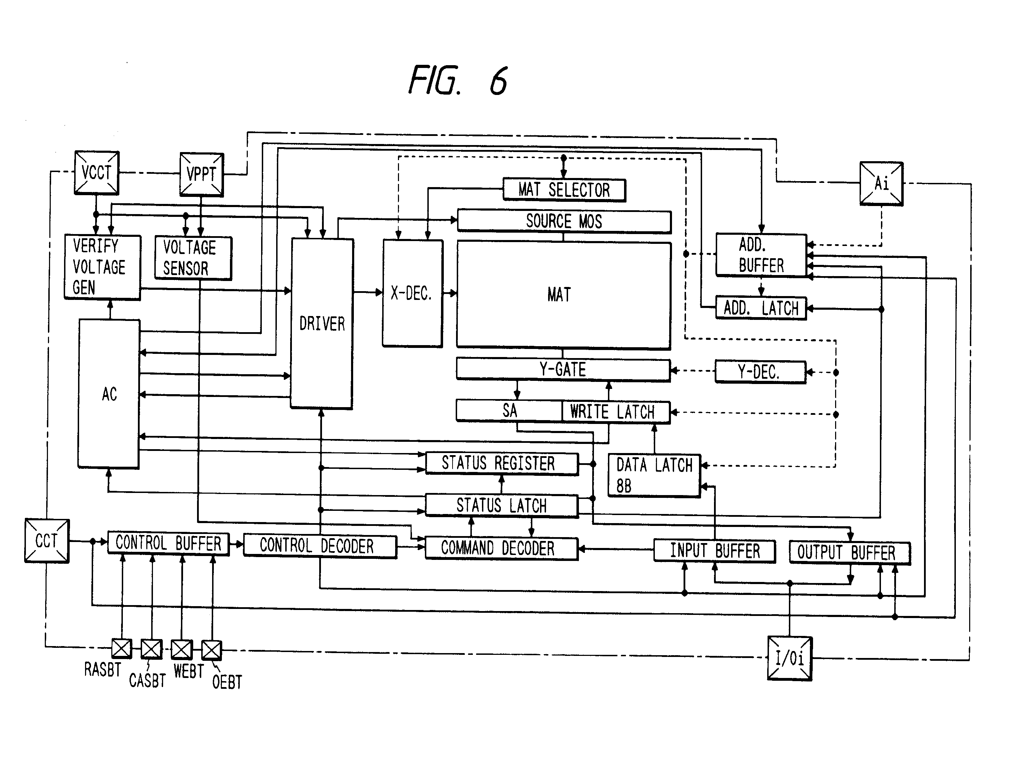

Fig. 6 is a block diagram showing the inside of one embodiment of the aforementioned Flash. The individual circuit blocks of Fig. 6 are formed on one semiconductor substrate made of a single crystal of silicon or the like by the technique of manufacturing the well-known semiconductor integrated circuit device. The Flash memory of this embodiment is basically similar to the general-purpose memory but is considerably different therefrom in that it is equipped with the chip control terminal CCT for the aforementioned data transfer and in that the address inputting method is made to match the DRAM.

The individual signals from the chip control terminal CCT and other control terminals RASBT, CASBT, WEBT and OEBT are inputted to the Control Buffer. The signal from the chip control terminal CCT is fed to the Output Buffer and the address buffer (Add. Buffer) in addition to the aforementioned control buffer so as to activate all the pins, as described above, and to switch them into the high-impedance state.

The individual control signals RASB, CASB, WEB and OEB through the control buffer are fed to the Control Decoder, in which are produced control signals and timing signals according to the operation modes. The individual circuits to be controlled by that control decoder are the driver DRIVER for driving the word lines of the memory mat MAT, the Status Register, the Status Latch, the Command Decoder, the Input Buffer, and the aforementioned output buffer and address buffer. The content of the status register is referred to when the state of the chip is examined by the CPU. The status latch latches the command coming from the CPU.

The command decoder decodes the command inputted through the input buffer and transmits the corresponding control signal through the status latch to the Auto Control circuitAC. This Auto Control circuit AC executes the processing with reference to the aforementioned status latch. For example, the Auto Control circuit AC produces a series of address signals, a prewriting write pulse and an erasing erase pulse, if the erasure is instructed, in accordance with the aforementioned erase algorithm, and produces a series of address signals and the write pulse, if the writing operation is instructed, in accordance with the aforementioned write algorithm.

The power supply voltage at 5 V fed from the terminal VCCT and the high/low voltages fed from the terminal VPPT are inputted to the verify voltage generator (Verify Voltage Gen) to output an erasure verifying voltage as low as about 3.5 V for setting the selecting level of the word lines and switch the write verifying voltage. The Voltage sensor detects the high/low voltages from the power supply voltage terminal VCCT and the terminal VPPT and feeds the detection result to the command decoder.

In response to the aforementioned voltages VCC and VPP and the low voltage, the aforementioned driver sets the selecting level of he word line selected by an X-decoder (X-DEC) and the erasing level to be fed to the source switch (Source MOS) at the erasing time. In this embodiment, a memory mat MAT can also be erased at the unit of block, as will be described hereinafter. Therefore, the block to be erased by the MAT selector is selected. In other words, the selecting switch for the erasing source switch disposed at each of the aforementioned divided mats is produced by the aforementioned mat selector. By adopting the negative voltage erasing method, although not especially limited thereto, the erasure can also be executed at the unit of word line.

The data lines of the memory mat MAT are selected bythey-gate circuit (Y-Gate) and are selected with the input of the sense amplifier SA and the output of the Write Latch. In other words, they-gate circuitcon- nects the data line of the memory mat with the input/output common data line. The aforementioned sense amplifier and write latch are disposed in that common data line. Since all the memory cells are dropped to "1" by the erasing operation, the memory cell corresponding to "0" of the write data fetched by the write latch is substantially written. The data 0 of the write latch corresponding to the bit, which has been verified to be sufficiently written, is rewritten to "1", and the end of the writing operation is decided if all the data of the write latch are rewritten to "1 ".

The Data Latch is used to store the write data of 8 bytes (8B) and to write a page of 8 x 8 (= 64 bits) in the memory mat MAT. In the write mode using the data latch, data of 8 bytes are written in the data latch at a first stage, and the page is then written in a batch in the aforementioned 8 x 8 memory cells.

An input terminal of the input buffer and the output terminal of the output buffer are connected with a data input/output terminal I/Oi. This data input/output terminal I/Oi is composed of either terminals. As a result, the data are inputted and outputted atthe unit of 8 bits from the outside.

The X-line row address signal and Y-line column address signal, which are inputted in time series in synchronism with the address strobe signals RASB and CASB, as described above, are inputted through the common address terminal Ai to the address buffer. The X-line row address signal is inputted to and latched in the X-decoder to produce the word line selecting signal. The Y-line column address signal is inputted to the Y-decoder to provide the Y-gate circuit selecting signal for connecting the data lines with the common data line.

The address latch (Add. Latch) is used to store the address of the leaching sector and block or the final sector and block when it is additionally given a function to erase the memory mat MAT at the unit of a plurality of sectors and blocks. With reference to the content of the address latch, the auto control executes the erasing operation of a plurality of blocks. Incidentally, in Fig. 6, broken lines indicate the transmission paths of the address signals, and other solid lines indicate the transmission paths of the data and the control signals.

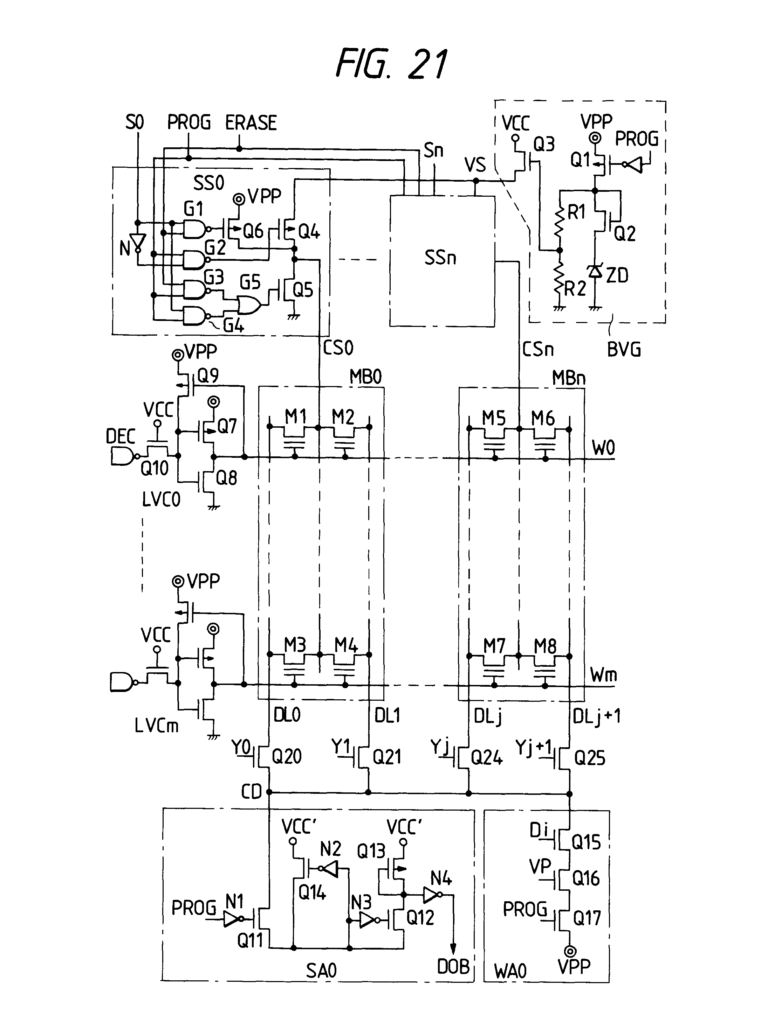

Fig. 21 is a circuit diagram showing one embodiment of the aforementioned memory mat MAT and its major peripheral circuits. The individual circuit elements of Fig. 21 are manufactured by the technique of manufacturing the well-known CMOS (i.e., Complementary MOS) integrated circuit. In Fig. 21, the P-channel MOSFETs are discriminated from N-channel MOSFETs by adding arrows to their channel (or back gate) portions. These discriminations apply to other Drawings.

Although not especially limitative, the integrated circuit is formed on a semiconductor substrate made of a single crystal of P-type silicon. The N-channel MOSFET is constructed to include a source region and a drain region, which are formed in the surface of the semiconductor substrate, and a gate electrode of poly-silicon formed through a thin gate insulating film in the surface of the semiconductor substrate between the source region and the drain region. The P-channel MOSFET is formed in an N-type well region which is formed in the surface of the aforementioned semiconductor substrate. As a result, the semiconductor substrate constitutes a common substrate gate forthe plurality of N-channei MOSFETs formed thereover. The N-type well region constitutes the substrate gate of the P-channel MOSFETs formed thereover. The substrate gate of the P-channel MOSFETs, i.e., the N-type well region is coupled to the power supply voltage VCC. If in a high-voltage circuit, however, the N-type well region formed with the corresponding P-channel MOSFETs is connected with the high voltage VPP supplied from the outside or an internal high voltage. Alternatively, the integrated circuit may be formed on the semiconductor substrate made of a single crystal of N-silicon. In this case, the N-channel MOSFETs and the n memory elements are formed in the P-type well region, and the P-channel MOSFETs are formed on the N-type substrate. Incidentally, in the present invention, the terms "MOSFET" is used to mean an insulated gate type field effect transistor (IGFET).

The aforementioned memory mat MAT is representatively exemplified by two memory blocks MBO and MBn. These memory blocks are constructed to include memory cells (i.e., nonvolatile memory elements: MOSFETs M1 to M8) having a stacked gate structure having a control gate and a floating gate, word lines WO to Wm, and data lines DLO and DL1 to DLj and DLj+1. The aforementioned memory cells M1 to M8 are given structures similar to those of the memory cells of the EPROM of the prior art, although not especially limited thereto, but are different from the erasing method of the EPROM of the prior art using ultraviolet rays, in that the erasing operation is electrically carried out by making use of the tunnel phenomenon between the floating gates and the sources coupled to the source lines, as will be described hereinafter.

In the memory blocks MBO and MBn, as exemplified above, the memory cells M1 and M2, and M5 and M6 (or M3 and M4, and M7 and M8) arranged on a common row have their control gates connected with the corresponding word line WO (or Wm). The word line WO and Wm are driven by the level converters LVCO and LVCm constituting the word drivers. If the aforementioned decoder DEC has its output dropped to the low level, this low level is transmitted through a cutting MOSFET Q10 to turn OFF an N-channel type MOSFET Q8 and to turn ON a P-channel type MOSFET Q7. As a result, the high voltage VPP is transmitted to the word line W0. If the output signal of the aforementioned decoder DEC is at the high level, the N-channel type MOSFET Q8 is turned ON through the cutting MOSFET Q10 to drop the word line WO to the low level such as the earth potential of the circuit. In response to this low level, a feedback P-channel type MOSFET Q9 is turned ON to raise the input signal to the high voltage VPP. As a result, the P-channel type MOSFET Q7 can be turned OFF. As the input signal rises, the cutting MOSFET Q10 is turned OFF so that a DC current can be prevented from flowing from the high voltage VPP to the decod- erDECwhich is operated bythe power supply voltage VCC to produce an output signal at the high level. Incidentally, the voltage VPP is switched to the voltage VCC when in the reading operation.

The memory cells M and M3, and M2 and M4 arranged on the common columns have their drains individually connected with the corresponding data lines DLO and DL1, and the memory cells M5 and M7, and M6 and M8 arranged on the common columns have their drains individually connected with the corresponding data lines DLj and DLj+1. The memory cells M1 to M4 of the memory block MBO have their sources connected with the corresponding common source line CSO, and the memory cells M5 to M8 of the memory block MBn have their sources connected with the corresponding common source line CSn.

Although not especially limitative, a plurality of, such as, totally eight sets (or sixteen sets) of memory arrays are provided for the writing/reading operations at the unit of a plurality of, such as 8 bits (or 16 bits). Fig. 21 shows a circuit of one of the bits.

The individual data lines DLO to DLj+1 constituting the aforementioned one memory array are connected with the common data line CD through column selecting switch MOSFETs Q20 and Q21 to Q24 and Q25 acting as Y-gates made receptive of select signals YO and Y1 to Yj and Yj+1 produced by the aforementioned Y-decoder. The common data line CD is connected with the output terminal of a write amplifier WAO. This write amplifier WAO is constructed of a series circuit which includes: a MOSFET Q15 made receptive of the output signal Di of the writing data input buffer made receptive of the write signal inputted from the corresponding one 1/00 of the data input/output terminals 1/00 to 1/07; a MOSFET Q16 made receptive of the bias voltage VP; and a MOSFET Q17 made receptive of the control signal PROG. The write amplifier WAO transmits the voltage of the high-voltage terminal VPP to the common data line CD. The MOSFET Q16 is used to prevent a high voltage such as the high voltage VPP from being directly applied between the drains and the gates of the MOSFETs Q17 and Q15. By inserting the MOSFET Q16 having its gate fed with an intermediate high voltage VP, those voltages are divided to reduce the voltages to be applied to the individual MOSFETs Q17 and Q15.

The aforementioned common data line CD is coupled on the other hand to the input terminal of the input stage circuit of the sense amplifier SAO through a switch MOSFET Q11. The sense amplifier SAO is constructed to include MOSFETs Q12 to Q14 for amplifying the input stage, inverters N2 and N3 for controlling them, and a CMOS inverter N4. The sense amplifier SAO is fed as its operating voltage VCC'with the power supply voltage VCC such as 5 V when in an ordinary reading operation and a lower voltage such as 3.5 V switched from the aforementioned value of 5 V when in the erasure verifying operation, although not especially limited thereto. The aforementioned MOSFET Q11 is so controlled by the output signal of an inverter N1 made receptive of the control signal PROG that it is turned OFF when in the writing operation. As a result, the relatively high potential of the common data line CD at the writing operation is not fed to the input of the sense amplifier SAO.

The storage level of the memory cell read out to the common data line CD is connected through the MOSFET Q11, which is turned ON at the reading time, with the source of the N-channel type amplifying MOSFET Q12 which is connected with the source of the MOSFET Q11. Between the drain of the amplifying MOSFET Q12 and the power supply voltage terminal VCC', there is connected the P-channel type load MOSFET Q13 which has its source connected with the gate of the MOSFET Q12. The aforementioned load MOSFET Q13 operates to feed the precharge current to the common data line CD for the reading operation.

In order to enhance the sensitivity of the aforementioned amplifying MOSFET Q12, the voltage of the common data line CD through the switch MOSFET Q11 is fed to the inputs of the inverters N2 and N3 acting as inverting amplifiers. The output of the inverter N3 acting as the inverting amplifier is fed to the gate of the amplifying MOSFET Q12. Moreover, the aforementioned source input is charged up from the power supply terminal VCC' through the MOSFET Q14 acting as a limiter. This MOSFET Q14 has its gate fed with the output signal of the inverter N2 as the inverting amplifier.

At the reading time of the memory cells, the memory cells take a threshold voltage higher or lower than the selecting level of the word lines in accordance with the data charges stored in the floating gates. In case the memory cells selected by the aforementioned X- and Y-decoders are OFF despite that the word lines are at the selecting level, the common data line CD is raised to a relatively high level by the current supplied from the MOSFETs Q12 and Q14. On the other hand, in case the selected memory cells are turned ON by the word line selecting level, the common data line CD is set to a relatively low level.

In this case, the high level of the common data line CD is limited to a relatively low potential by the fact that the MOSFET Q14 has its gate fed with the output voltage at a relatively low level, which is produced by the inverting amplifier made receptive of that high level. On the other hand, the low level of the common data line CD is limited to a relatively high level by the fact that the MOSFET Q14 has its gate fed with the voltage at a relatively high level, which is produced by the inverting amplifier made receptive of the potential at that low level. By these level limiting actions of the common data line CD, the signal changing rate can be substantially accelerated when the stored data to be continuously read out from the memory cells change from the level "1" to the level "0" or from the level "0" to the level "1".

The aforementioned amplifying MOSFET Q12 amplifies the input to the gate grounded type source and transmits its output signal to the input of the CMOS inverter N4. The CMOS inverter N4 shapes the waveform of the drain output signal of the amplifying MOSFET Q12 and transmits the shaped signal to the input of the corresponding data output buffer DOB. This data output buffer DOB amplifies the signal from the aforementioned sense amplifier SAO and sends it out of the corresponding data input/output terminal 1/00. Although omitted from Fig. 21, moreover, the write signal fed from the aforementioned data input/output terminal 1/00 is inputted to the data input buffer, the output signal Di of which is fed to the gate of the MOSFET Q15 of the write amplifier WAO.

In this embodiment, in order to make a selective erasing operation possible for each of the memory blocks MBO to MBn, the common source lines CSO to CSn of the individual memory blocks MBO to MBn are individually equipped with source switch circuits SSO to SSn acting as the erasure control circuits. In Fig. 21, these source switch circuits are representatively exemplified by a specific circuit of the source switch circuit SSO.

The source switch circuit SSO is constructed, although not especially limitative, to include: a P-channel type MOSFET Q6 for feeding the high voltage VPP to the common source line CSO at the erasing time; an N-channel type MOSFET Q5 for feeding the earth potential of 0 V to the common source line CSO at the writing time; and a P-channel MOSFET Q4 for feeding the intermediate bias voltage VS which is produced by a later-described bias voltage generator BVG. Those MOSFETs Q4 and Q5 are complementarily switched and controlled at the writing time.

The P-channel type MOSFET Q6 has its gate fed with the output signal of a NAND gate circuit G1 which is made receptive of a block select signal SO and an erasure control signal ERASE. The P-channel type MOSFET Q4 has its gate fed with the output of an inverter N, which is made receptive of the aforementioned block select signal S0, and the output signal of a NAND gate circuit G2 which is made receptive of a write control signal PROG. Moreover, the N-channel type MOSFET Q5 has its gate fed with the output signal of an OR gate circuit G5. This OR gate circuit G5 has its input fed with the output signal of a NOR gate circuit G3, which is made receptive of the erasure control signal ERASE and the write control signal PROG, and the output signal of an AND gate circuit G4 which is made receptive of the write control signal PROG and the block selecting signal S0.

In the reading operation or the like otherthan the writing/erasing operations, both the aforementioned control signals ERASE and PROG are set to the low level "0". As a result, the output signal of the NOR gate circuit G3 takes the high level "1" to raise the output signal of the OR gate circuit G5 to the high level so that the MOSFET Q5 is turned ON. At this time, the output signals of the NAND gate circuits G1 and G2 are raised to the high level in response to the low level "0" of the aforementioned signals ERASE and PROG so that both the P-channel type MOSFETs Q4 and Q6 are turned OFF. As a result, the common source line CSO is fed with the earth potential of the circuit by the MOSFET Q5 which is turned ON.

In the writing operation, the aforementioned erasure control signal ERASE is set to the low level whereas the write control signal PROG is set to the high level. In the memory block MBO to be written, the output signal of the AND gate G4 is set to the high level in response to the high level of the write control signal PROG and the high level of the block selecting signal SO to set the output signal of the OR gate circuit G5 to the high level like before. As a result, the MOSFET Q5 is turned ON to feed the earth potential of the circuit to the common source line CSO. At this time, in response to the low level of the erasure control signal ERASE, the output signal of the NAND gate circuit G1 is set to the high level to turn OFF the MOSFET Q6. In response to the high level of the block selecting signal S0, moreover, the output signal of the inverter N is dropped to the low level to raise the output signal of the NAND gate circuit it G2 to the high h level. As a result, the MOSFET Q4 is also turned OFF.

If the aforementioned memory block MBO is not written by writing another memory block when in the writing operation to set the aforementioned erasure control signal ERASE to the low level and the write control signal PROG to the high level, the output signal of the NAND gate circuit G2 is set to the low level in response to the high level of the output signal of the inverter N made receptive of the low level of the block selecting signal SO and the high level of the write control signal PROG. As a result, the P-channel type MOSFET Q4 is turned ON so that the bias voltage VS produced by the bias voltage generator BVG is fed to the common source line CSO. At this time, in response to the low level of the erasure control signal ERASE, the output signal of the NAND gate circuit G1 is set to the high level to turn OFF the MOSFET Q6. Moreover, since the output signal of the AND gate circuit G4 is given the low level by the low level of the block selecting signal SO and since the output signal of the NOR gate circuit G3 is given the low level by the high level of the write control signal PROG, the output signal of the OR gate circuit G5 is also dropped to the low level to turn OFF the MOSFET Q5.

In the erasing operation, the aforementioned erasure control signal ERASE is set to the high level whereas the write control signal PROG is set to the low level. In the memory block MBO to be erased, the output signal of the NAND gate circuit G1 is set to the low level in response to the high level of the erasure control signal ERASE and the high level of the block selecting signal S0, to turn ON the P-channel type MOSFET Q6. As a result, the common source line CSO is fed with the high voltage VPP. At this time, in response to the low level of the write control signal PROG, the output signal of the NAND gate circuit G2 is set to the high level to turn OFF the MOSFET Q4. In response to the low level of the write control signal PROG, moreover, both the output signals of the NOR gate circuit G3 and the AND gate circuit G4 are set to the low level so that the output signal of the OR gate circuit G5 is also set to the low level to turn OFF the MOSFET Q5.

In the erasing operation, the aforementioned erasure control signal ERASE is set to the high level, whereas the write control signal PROG is set to the low level. If the memory block MBO is not erased as other memory blocks are erased, the common source line CSO is held in the high-impedance state. Specifically: in response to the low level of the write control signal PROG, the output signal of the NAND gate circuit G2 is raised to the high level so that the MOSFET Q4 is turned OFF; in response to the high level of the erasure control signal ERASE the output signal of the NOR gate circuit G3 is set to the low level whereas in response to the low level of the write control signal PROG the output signal of the AND gate circuit G4 is set to the low level so that the MOSFET Q5 is turned OFF; and in response to the low level of the block selecting signal SO the output signal of the NAND gate circuit G1 is set to the high level so that the MOSFET Q5 is turned OFF. This construction may be replaced by another in which the common source line CSO of the memory block to be unerased is set to the earth potential of the circuit. Specifically, the erasure control signal ERASE and the block selecting signal inverted by the inverter may be fed to the AND gate circuit to feed its output signal to the input of the aforementioned OR gate circuit G5. The constructions and operations of other source switch circuits SS1 to SSn are similar to the aforementioned circuit, although their specific circuits are not shown, so that their descriptions will be omitted.

In the bias voltage generator BVG, a Zener diode ZD and a current limiting MOSFET Q2 are connected in series. This series circuit is fed with the high voltage VPP through a P-channel type MOSFET Q1 which is switched and controlled by the output signal of the inverter made receptive of the write control signal PROG. Although not especially limitative, the voltage, which is produced by adding the threshold voltage between the gate and source of the MOSFET Q2 to the Zener voltage, is divided by series resistors R1 and R2. This divided voltage is transmitted to the gate of a source follower output MOSFET Q3. This MOSFET Q3 has its drain connected with the powersupply voltage VCC to output a bias voltage Vs from its source.

If the MOSFETs Q2 and Q3 have substantially equal threshold voltages, the Zener constant voltage by the Zener diode ZD is divided in this embodiment by the resistors R1 and R2. As a result, it is possible to produce a constant voltage which has no dependency upon the power supply voltage VCC and the high voltage VPP. By feeding this constant voltage VS in the writing operation to the common source line of the memory block left unwritten, the voltage difference between the floating gate and source of the erased memory cell in the memory block left unselected to be written is reduced to prevent the tunnel injection current from flowing therethrough substantially.

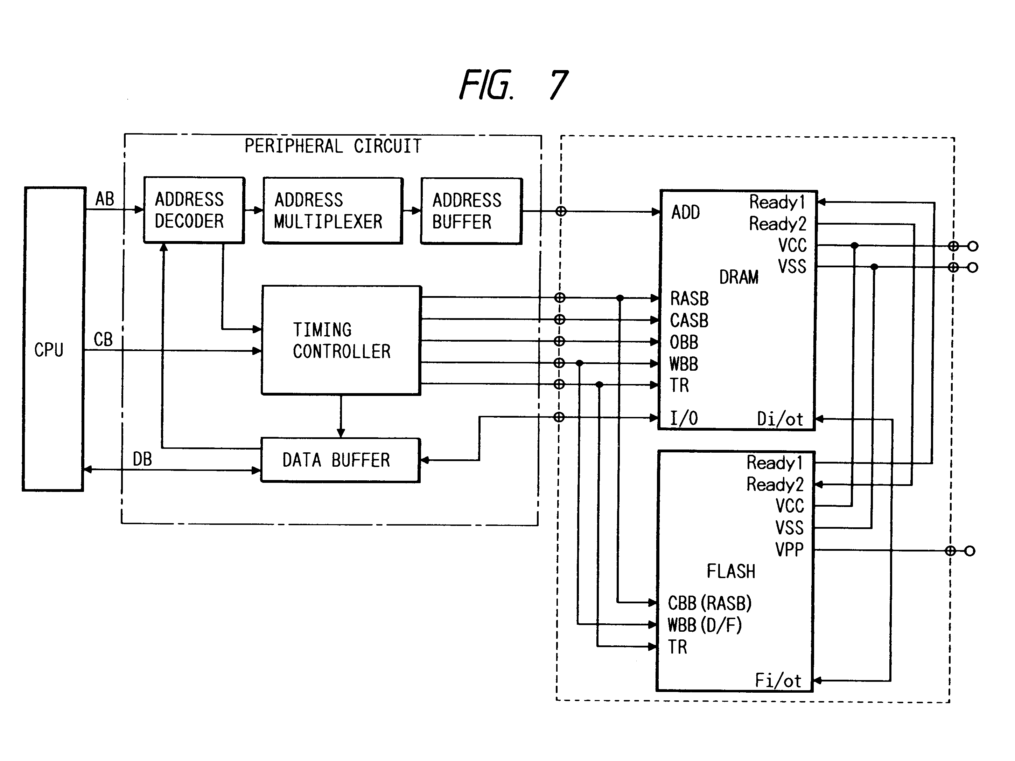

Fig. 7 is a block diagram showing a semiconductor memory device according to another embodiment of the present invention and a microcomputer system using the semiconductor memory device.

The semiconductor memory device of this embodiment is constructed by packaging two memory chips in one package,as indicated by broken lines in Fig. 7. In this embodiment, the data transfer between the two memory chips DRAM and FLASH are executed in the package. In other words, the data are automatically transferred in the semiconductor memory device from the DRAM to the FLASH or from the FLASH to the DRAM not through the CPU as in the foregoing embodiment of Fig. 1.

In order to make the aforementioned data transfer possible, there is added a control signal TRfor instructing the transfer direction. Control terminals ready1 and ready2 are provided for transferring the data between the DRAM and the FLASH. Moreover, only the DRAM can be accessed from the outside, but the FLASH is given only the role for backing up the stored data of the DRAM. As a result, the FLASH is equipped with no address terminal, and the data terminal I/O is connected in the package with the data terminal I/O especially for the transfer of the DRAM. Moreover, the control signals used for assigning the operation mode are the combination of the chip enable signal CEB and the write enable signal WEB and the control signal TR to be fed to the aforementioned newly added terminal with the signals of the control terminals ready1 and ready2 to be transferred between them and the DRAM. The aforementioned chip enable signal CEB is commonly connected with the address strobe signal RASB of the DRAM, and the write enable signal WEB is also commonly connected with the write enable signal WEB of the DRAM. Incidentally, the chip enable signal CEB may be the address strobe signal RASB, and the write enable signal WEB may be a signal D/F meaning the data writing of the DRAM/FLASH. Specifically, in the data transferring operation, the write enable signal WEB is used to instruct the transfer direction. For example, the data are written in the DRAM, if the write enable signal WEB is at the high level, and in the FLASH if the write enable signal WEB is at the low level.

If the signal TR is dropped to the low level, the DRAM mode comes so that the memory access to the DRAM can be carried out from the outside. In this meanwhile, the FLASH side is held in the standby state. If the signal TR is raised to the high level, the data transfer from DRAM to the FLASH or the data transfer from the FLASH to the DRAM is instructed. Thus, when the signal TR rises to the high level, the data transfer is executed from the DRAM to the FLASH, if the write enable signal WEB is at the high level, and the data transfer is executed from the FLASH to the DRAM if the write enable signal IVEB is at the low level.

The signal ready1 indicates the operating state of the FLASH to activate the DRAM only for ready1 = 1 (i.e., the high level) at the transfer time. The signal ready2 indicates the operating state of the DRAM to activate the FLASH only for ready2 = 1 (i.e., the high level) at the transfer time.

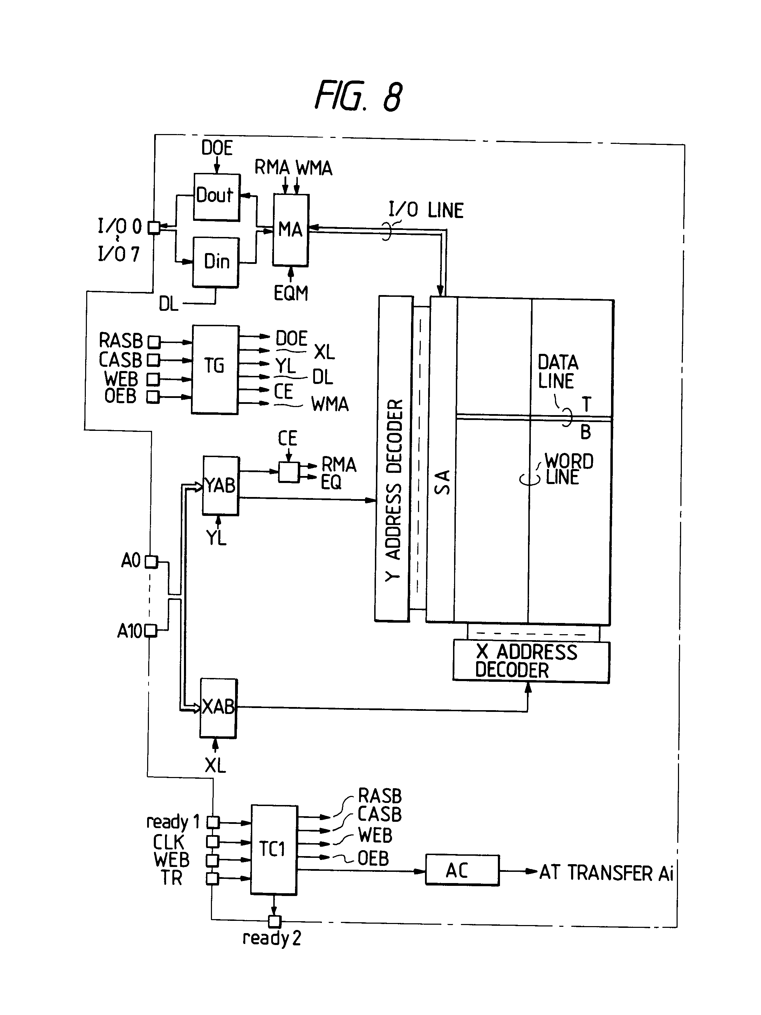

Fig. 8 is a block diabram showing the inside of one embodiment of the aforementioned DRAM. The individual circuit blocks of Fig. 8 are formed on one semiconductor substrate made of a single crystal of silicon by the technique for manufacturing the well-known semiconductor integrated circuit.

An X-address buffer XAB and a Y-address buffer YAB fetches the X- and Y-address signals inputted from address terminals AO to A10, in response to latch control signals XL and YL which are generated in synchronism with the row address strobe signal RASB and the column address strobe signal CASB.

The memory array is constructed to have the folded data line structure, in which a pair of complementary data lines (Data Line) of non-inverted data line T and inverted data line Bare arranged in parallel. These complementary data lines are connected with a pair of input/output terminals of a differential sense amplifier (SA). The Word Lines are arranged to intersect the aforementioned data lines at a right angle, and their intersections with the data lines are arranged with dynamic memory cells.

The X Address Decoder decodes the address signal inputted through the X-address buffer XAB, to set the aforementioned word lines to the selecting level. The Y Address Decoder decodes the address signal inputted through the Y-address buffer YAB, to produce the selecting signal of the column switch for selecting the aforementioned complementary data lines with the I/O Line. It should be understood in Fig. 8 that the column switch is also included in the portion of the sense amplifier.

A main amplifier MA amplifies the read signal read out to the aforementioned input/output line and sends it out through a data output buffer Dout from the external terminals 1/00 to 1/07. The write data inputted from these external terminals 1/00 to 1/07 are fetched in a data input buffer Din and are written in the memory cell through the writing main amplifier MA and via the aforementioned input/output line and the selected data line.

In response to the address strobe signals RASB and CASB, the write enable signal WEB and the out- putenable signal OEB, a timing generator TG produces timing signals DOE, XL,YL, DL, CE and WMA necessary for the operations of the internal circuits. The individual circuit blocks described above are basically similar to those of the DRAM of the prior art.

This embodiment is equipped with a transfer controller TC1 and a transfer address counter AC for automatic data transfer in the DRAM and the FLASH. In order to control the aforementioned transfer controller TC1, there are inputted the control signal ready1, the clock CLK and the signal TR for instructing the transfer operation. The aforementioned write enable signal WEB is also inputted as a signal for instructing the transfer direction.

The transfer controller TC1 produces the control signals RASB, CASB, WEB and OEB necessary for the reading and writing operations of the DRAM in a later-described transferring operation, and these control signals are transmitted by the internal signal paths to the aforementioned timing generator TG. As a result, the DRAM has its operations instructed not by the control signals fed from the external terminals but by the control signals produced by the internal transfer controller TC1.

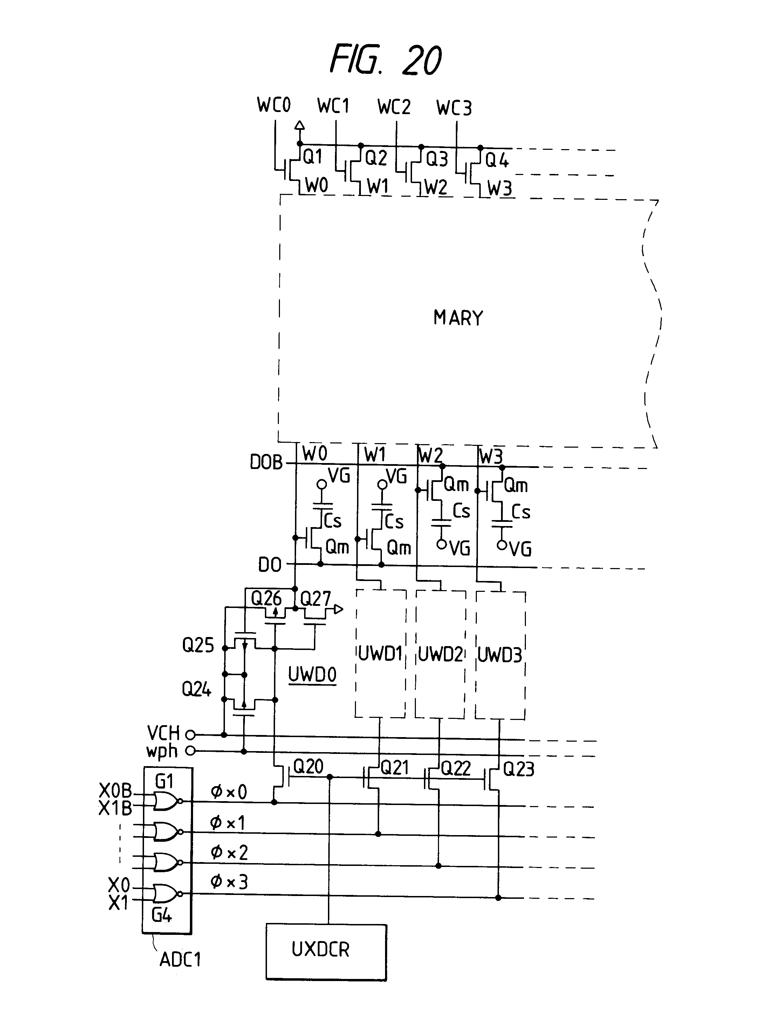

Fig. 20 is a circuit diagram showing one embodiment of the memory array of the aforementioned DRAM and the X-address selector of the peripheral circuits of the former.

The memory array MARY, as exemplified, is of two-intersection (or folded bit line) type, although not especially limited thereto. Fig. 20 shows one pair of rows representatively by way of example. To one pair of complementary data lines (e.g., bit lines or digit lines) DO and DOB arranged in parallel, there are coupled in a distribution having a predetermined regularity, as shown, the input/output nodes of a plurality of memory cells which are constructed to include an address selecting MOSFET Qm and a data storing capacitor Cs.

Between the complementary data lines DO and DOB, as representatively sown, there is connected a not-shown switch MOSFET which is turned ON in the chip un-selected state or before the memory cell comes into the selected state. As a result, in the preceding operation cycle, the high level and the low level of the complementary data lines DO and DOB by the amplifying operation of the sense amplifier are short-circuited to set the complementary data lines DO and DOB to a precharge voltage at about VCC/2 (HVC). In case the DRAM chip is held in the unselected state for a relatively long time period, although not especially limited thereto, the precharge level of the aforementioned complementary data lines DO and DOB drops due to a leakage current or the like. Therefore, the half precharge voltage HVC may be fed through the switch MOSFET. The voltage generator for establishing the half precharge voltage HVC is enabled to supply a relatively low current to compensate the aforementioned leakage current or the like. Thus, the increase in the power consumption is suppressed.

The X-address decoder is divided into a first address decoder ADC1 composed of gate circuits G1 to G4 and a second address decoder such as a unit circuit UXDCR, although not especially limited thereto. Fig. 20 shows one circuit (or unit circuit) UXDCR constituting the second address decoder, and the NOR gate circuits G1 to G4 constituting the first address decoder. Incidentally, the gate circuits G2 and G3 have their circuit symbols omitted. The aforementioned unit circuit UXDCR produces decode signals for the four word lines.

The four gate circuits G1 to G4 constituting the first X-decoder produce four kinds of word line selecting timing signals ₀ x0 to ₀ x3 by combining address signals XOB and X1 B to XO and X1 of less significant 2 bits. These word line selecting timing signals ₀ x0 to ₀ x3 are inputted to unit word line drivers UWDO to UWD3 through the aforementioned transmission gate MOSFETs Q20 to Q23 which are switched and controlled by the aforementioned second address decoder UXDCR.

The word line driver WD is constructed, as representatively exemplified by the unit circuit UWDO, to include: a CMOS driver composed of a P-channel type MOSFET Q26 and an N-channel type MOSFET Q27; and P-channel type MOSFETs Q24 and Q25 connected between the input of the CMOS driver and the operating voltage terminal VCH. In response to the low level of the word line selecting timing signal 0x0, the P-channel type MOSFET Q26 is turned ON to output the boosted voltage VCH, which is made higher by the threshold voltage of the MOSFET than the power supply voltage VCC, to the selected word line W0. The P-channel type MOSFET Q24 has its gate fed with a precharge signal wph. The P-channel type MOSFET Q25 has its gate fed with the driving output of the word line W0.

When the word line selecting timing signal ₀ x0 produced by the power supply voltage VCC is raised to the high level to set the word line WO to an unselected level such as the earth potential, the MOSFET Q25 responds to the low level to pull up the input level of the CMOS circuit to the high voltage VCH thereby to turn OFF the P-channel type MOSFET Q26 without fail. This prevents any DC current from being consumed between the P-channel type MOSFETs Q26 and Q27 constituting the CMOS drive circuit corresponding to the unselected word line.

By halving the X-address decoder, as described above, the pitch (or gap) of the unit circuits UXDCR constituting the second X-address decoder is enabled to match the pitch of the word lines. As a result, any spare space can be omitted from above the semiconductor substrate.

Between the remote ends of the word lines and the earth potential of the circuit, there are connected the switch MOSFETs Q1 to Q4. These switch MOSFETs Q1 to Q4 have their gates fed with signals WCO to WC3 which are out of phase from the selecting signals fed to the corresponding word lines WO to W3. As a result, only the switch MOSFET corresponding the selected word line is turned OFF, whereas the remaining switch MOSFETs are turned ON. This makes it possible to prevent the unselected word lines from being raised to an intermediate potential by the capacitance coupling due to the rise of the selected word line.

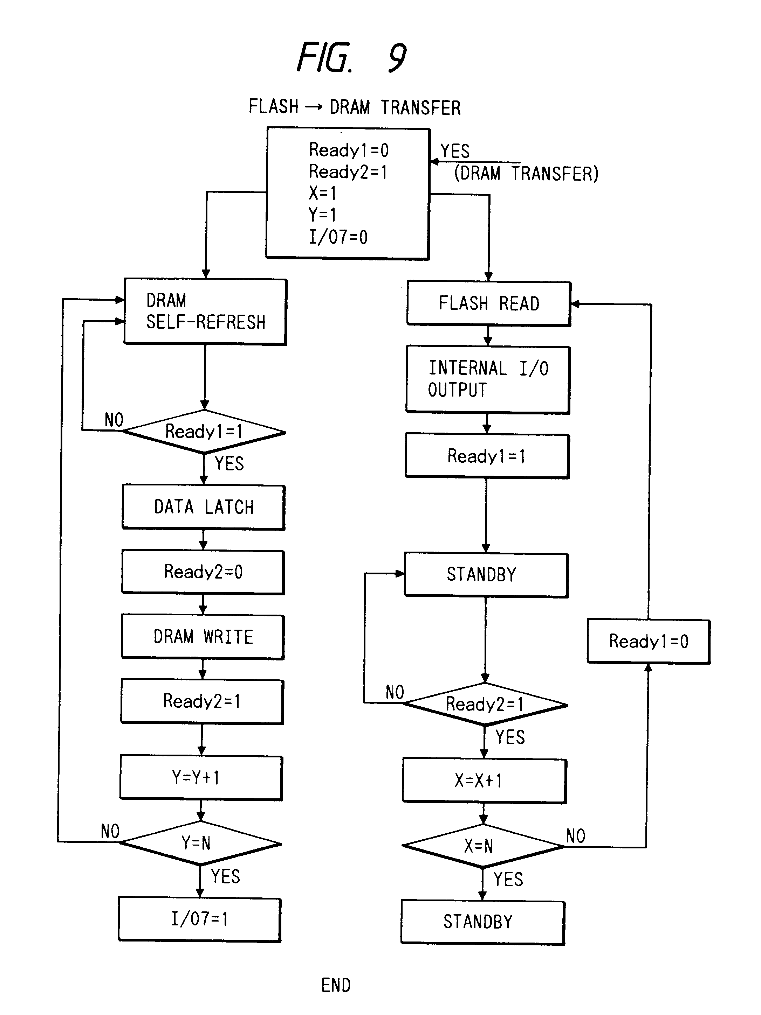

Fig. 9 is a flow chart showing one embodiment for explaining the data transfer operation from the aforementioned Flash to DRAM. When the signal TR changes from the low to high levels, as described above, although not shown, the transfer mode (i.e., DRAM transfer: YES) from the Flash to the DRAM is instructed in response to the low level of the signal WEB. In response to the signal TR at the high level, the transfer controller TC1 in the DRAM outputs the signal ready2 at the high level, and the transfer con- trollerTC2 in the FLASH outputs the ready1 atthe low level.

In this transfer mode, the initial setting of 1/07=0 is executed for ready1 =0, ready2=1, the X-line leading address X=1 and the Y-line leading address Y=1 of the DRAM and the FLASH. In response to ready1=0, the DRAM executing the self-refreshing operation till the ready1=1 is set by the Flash.

The Flash is activated by ready2=1 to come into the read mode in accordance with the aforementioned transfer direction so that the addresses are read from the leading one of X=1 and Y=1. When the output signal is sent out from the internal input/output terminal Fi/ot, the transfer controller TC2 outputs the ready1 at the high level.

In response to the aforementioned setting of ready1 =1 by the Flash, the DRAM is activated to latch the data of the internal output terminal Di/ot to set the signal ready2 to the low level. As a result, the Flash is brought into the standby state. Subsequently, the DRAM is brought into the write mode to write the data at the aforementioned same address X=1 and Y=1. After this, the transfer controller TC1 sets again the signal ready2 is set to to the high level and updates the Y-address to (Y+1). Unless the final address N, the DRAM transfers to the self-refresh.

In response to the aforementioned setting of ready2=1 by the DRAM, the Flash is activated to update the X-address to (X+1). Unless the final address X, the Flash is reset to the ready1=0 and comes into the aforementioned read mode. As a result, the next address X2 and Y2 is read out. From now on, similar operations are repeated till both the X-address and the Y-address reach the final address N. If the data transfer to the final address is ended, the terminal 1/07 is set to the high level (= 1), and the transfer end is decided by the polling of the CPU.

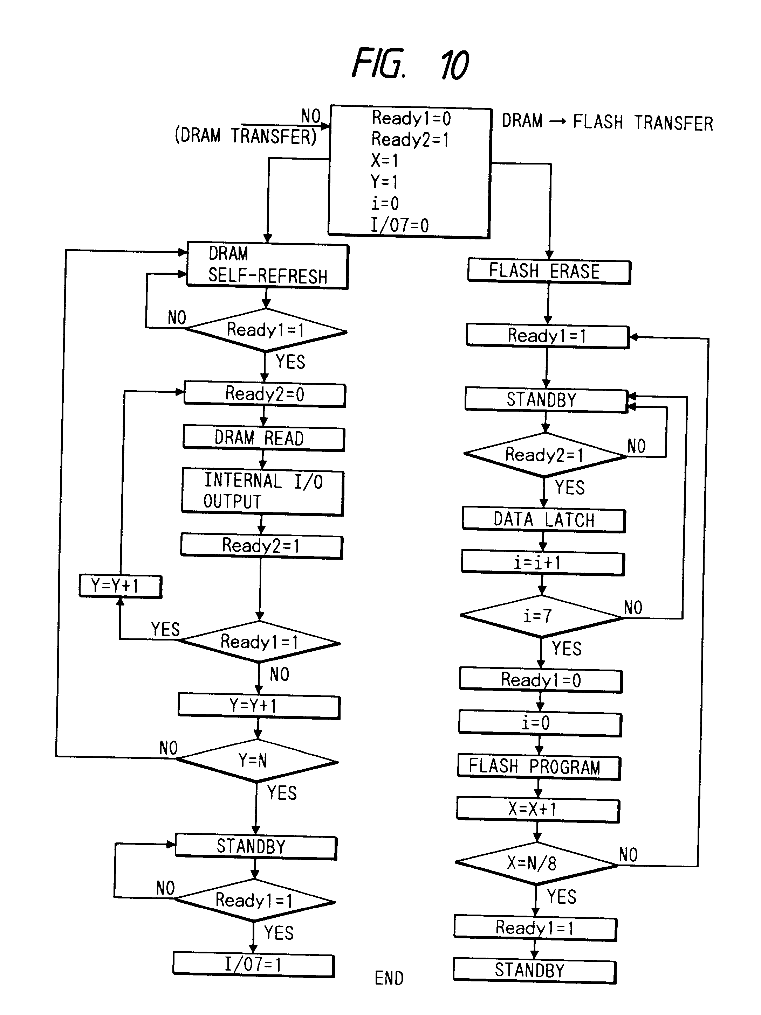

Fig. 10 is a flow chart showing one embodiment for explaining the data transfer operations from the aforementioned DRAM to Flash. When the signal TR changes from the low to high levels, as described above, although not shown, the transfer mode (i.e., DRAM transfer: No) from the DRAM to the Flash is instructed by the high level of the signal WEB.

In this transfer mode, the initial setting of 1/07=0 is executed for ready1=0, ready2=1, X=1, Y=1 and i=0. In response to the ready) =0, the DRAM is executing the self-refreshing operation till it is set to the ready1=1 by the Flash.

The Flash is activated for the ready2=1 and comes at first into the erasing mode to execute the batch-erasing operation in accordance with the aforementioned transfer direction. This erasing operation includes the aforementioned prewrite operation. At the end of the erasing operation, the Flash is set to the ready1=1 and is held in the standby state till it is set to the ready2=1 from the DRAM side.

When the aforementioned ready1 =1 is set by the Flash, the DRAM is reset to the ready2=0 to bring the Flash into the standby state. After this, the DRAM is brought into the read mode in accordance with the aforementioned transfer direction to read the addresses from the leading address X=1 and Y=1. If the output signal is sent out from the internal output terminal Di/ot, the transfer controller TC1 sets the signal ready2 to the high level.

In response to the ready2=1, the Flash is activated to latch the data outputted from the aforementioned DRAM in the data latch and to increment them to i = i + 1. Till this value i reaches 7, that is, till the data of 8 bytes are read out out from the DRAM and fetched in the data latch of the Flash, as described above, the aforementioned operations are repeated. Specifically, since the DRAM is left in the state of ready1=1 till i = 7, it increments the address to (Y + 1) and executes the following reading operation once it is reset to the ready2=0 to bring the Flash into the standby state.

If the data of 8 bytes are read out from the DRAM and fetched in the data latch of the Flash as a result of repetitions of the aforementioned operations, the Flash is reset to the ready) =0. As a result, the DRAM updates the Y-address to (Y + 1). If the address is decided not to be the final one, the first self-refresh mode is entered.

After clearance to i = 0, the Flash writes altogeth- erthe data of 8 x 8 bits fetched by the aforementioned data latch, to update the X-address to (X + 1). Unless the X-address is the final address N/8, the Flash is set to the ready1=1 and comes into the standby state. Specifically, the Flash is held in the standby state till the DRAM is set again to the ready2 =1, because the DRAM is activated and reset to the ready2=0 in response to the ready1 =1.

From now on, the operations, in which the Flash is written afterthe DRAM and the Flash are subjected eight times to the data transfer of 8 bits, are repeated till the final address. If the data transfer comes to the final address, the terminal 1/07 is raised to the high level, thus ending the aforementioned transfer operations. After this, all the data of the DRAM have already been transferred to the Flash side. Even if the microcomputer is energized by the electric power, the DRAM is in the standby state so that all the data will disappear after lapse of a predetermined time period. Specifically, this embodiment is intended to erase the data of the DRAM presuming the disconnection of the power supply to the system, after the aforementioned data transfer from the DRAM to the Flash. As a result, the aforementioned self-refreshing operation is not executed unless a demand for the self-refresh is made from the outside.

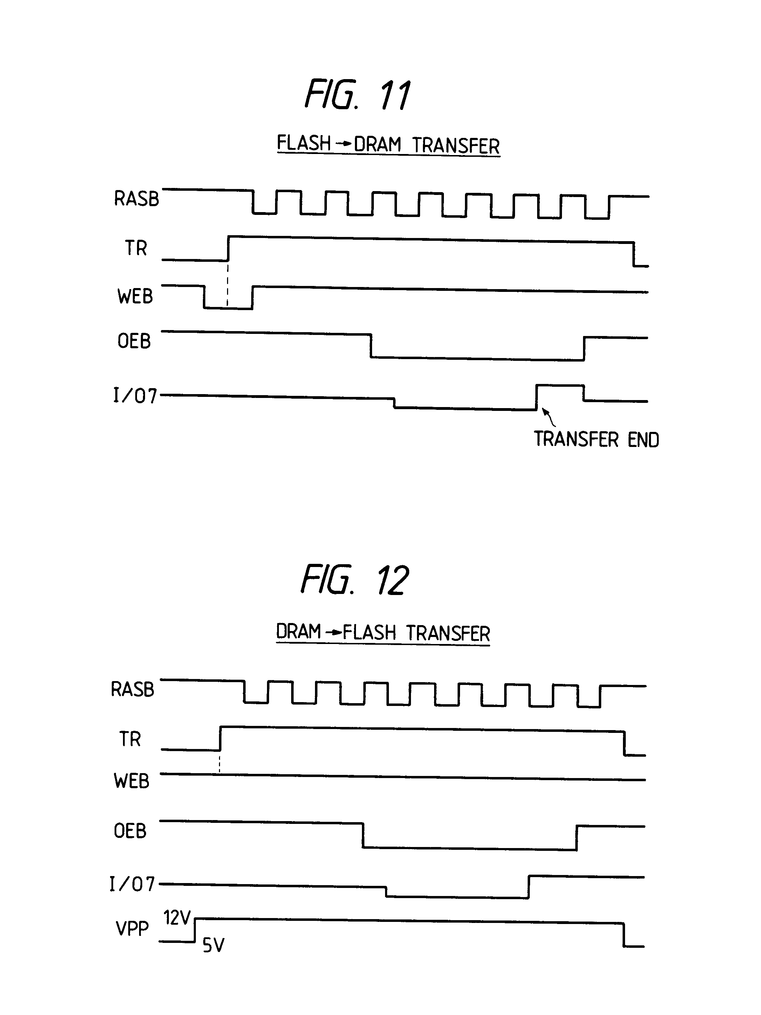

Fig. 11 is a timing chart illustrating one example of the aforementioned transferring operations from the Flash to the DRAM.

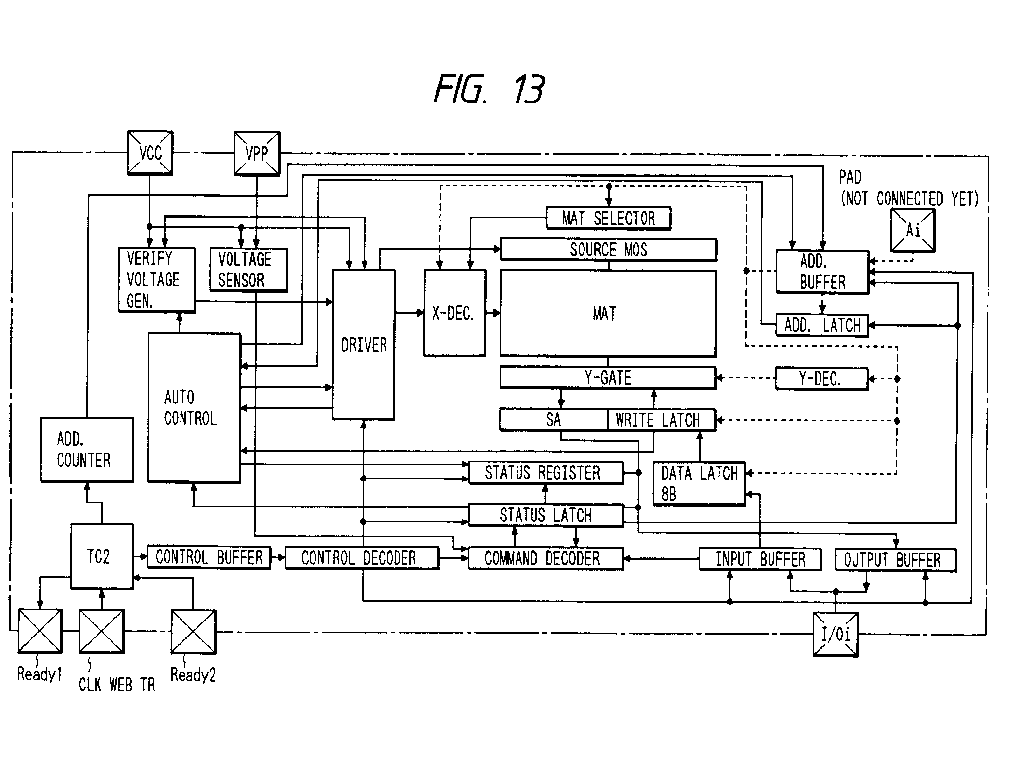

At the rising edge of the signal TR to the high level, the data transfer mode from the Flash to the DRAM is invited in response to the low level of the signal WEB. At this time, the clock pulse CLK necessary for the operation of the transfer controller of the DRAM or the auto controller of the Flash is inputted not from the external terminal CLK, as has been shown in Fig. 8 or will be shown in Fig. 13, but by making use of the external terminal RASB which is not used at this time. In other words, in the DRAM, the various control timing signals necessary for the reading operation or the writing operation are produced inside by the transfer controller while leaving the external terminal RASB unused. Thus, this external terminal RASB is used to input the system clock to be used in the microcomputer system or the like.

In response to the aforementioned clock pulse, there is accomplished the circuit operation necessary for the sequential data transfer between the two memory chips DRAM and Flash, as has been shown in Figs. 9 and 10. These Figures clarify the relations between the aforementioned mode settings and the clock pulse and omit from the illustrations the time period from the time when the terminal 1/07 changes from the low level to the high level midway of the data transfer to the time when the transfer is ended.

Fig. 12 is a timing chart illustrating one example of the aforementioned transferring operations from the DRAM to the Flash.

At the rising edge of the signal TR to the high level, the data transfer mode from the DRAM to the Flash is invited by the high level of the signal WEB. At this time, too, the clock pulse CLK necessary for the operations of the transfer controller of the DRAM or the auto controller of the Flash is inputted not from the external terminal CLK, as has been shown in Fig. 8 or will be shown in Fig. 13, but by making use of the external terminal RASB (or CEB in the embodiment of Fig. 7) which is not used at this time. These Figures clarify the relations between the aforementioned mode settings and the clock pulse and omit from the illustrations, as in the above, the time period from the time when the terminal 1/07 changes from the low level to the high level midway of the data transfer to the time when the transfer is ended.

Fig. 13 is a block diagram showing the inside of one embodiment of the Flash memory in case the data transferring operation is executed inside as in Fig. 7. The basic portions of the Flash memory of this embodiment are similar to those of the embodiment shown in Fig. 6. For the data transfer in the semiconductor memory device, however, there are provided the transfer control circuit and the transfer address counter (Add. counter) as in the DRAM of Fig. 8. Accordingly, the address terminal Ai is omitted. In this embodiment, the clock pulse CLK for the sequential operation of the transfer control circuit is fed from the control terminal. Alternatively, the signal CEB (or RASB) may be used as the clock input.

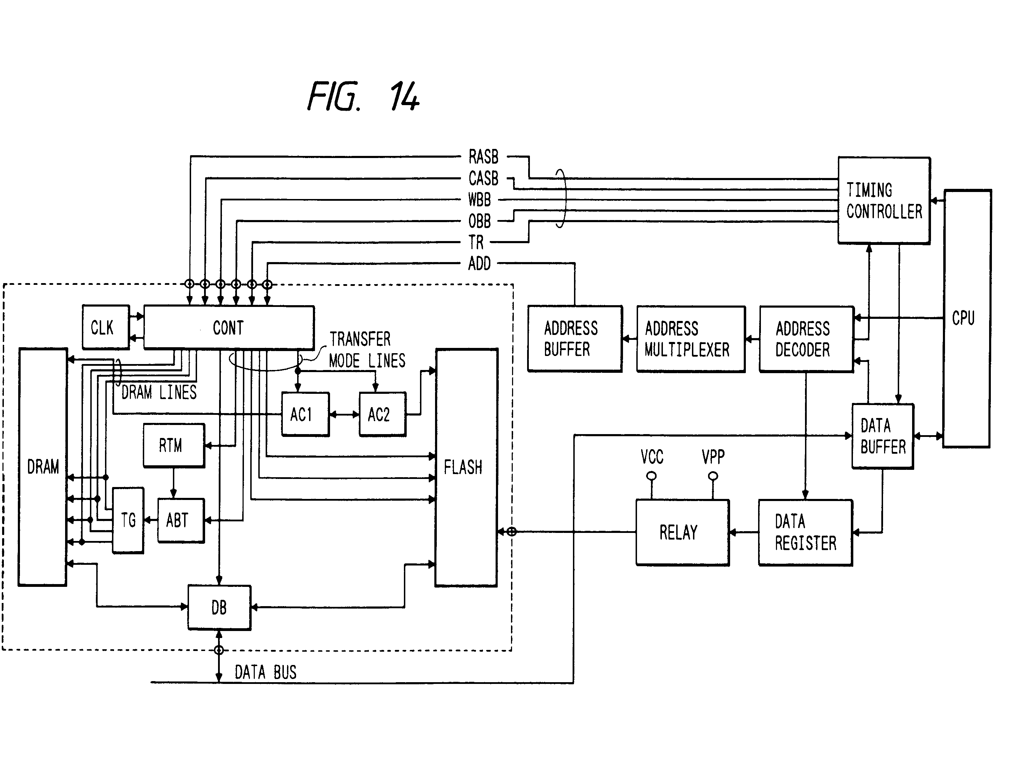

Fig. 14 is a block diagram showing a semiconductor memory device according to another embodiment of the present invention and a microcomputer system using the former.

The semiconductor memory device of this embodiment is constructed by packaging a control chip for data transferring operations in addition to a general purpose DRAM and a general purpose FLASH into one package. In Fig. 14, the control chip has its internal circuit blocks shown by way of example, so as to facilitate the understanding of the present invention. In other words, the circuit blocks excepting the DRAM and the FLASH are constructed as the control chip into one semiconductor chip.

In this embodiment, the data transfer between the two memory chips DRAM and the FLASH is executed inside of the package through the control chip. In otherwords, the transferring control signals are not packaged in the DRAM and the FLASH unlike the foregoing embodiment of Fig. 7 but are realized as similarfunctions in the external control chip. This construction is enabled to receive no restriction other than that the storage capacity of the FLASH is larger than that of the DRAM.

In the data transfer operations, data are read out from one of the FLASH and the DRAM and stocked in the data buffer DB and are written in the other by using the control unit. Here, reference letters CONT designate the control unit which bears a series of sequential operation controls necessary for the data transfer in response to the control signals RASB, CASB, WEB, OEB and TR coming from the CPU through the timing controller, and the clock pulse from the clock pulse generator CLK.

Characters AC1 designate an address counterfor generating an address signal for the address multiplex for the DRAM. Characters AC2 designates an address counter for generating an address signal for the address non-multiplex for the FLASH. Letters RTM designate a refreshing timer for controlling the self-refreshing operation in accordance with the data transfer direction. Letters ABT designate an arbiterfor arbitrating the refreshing operation and the memory accessing operation. Letter TG designates a timing generator for producing various timing pulses rasb, casb, web and oeb necessary for the operations of the DRAM.

To the system side, there are newly added a data register and a relay circuit for controlling the supply of the power supply voltages VCC and VPP. The data register is selected by the address decoder to receive the aforementioned commands from the CPU for the power supply control and controls the relay circuit responsively.

This embodiment may use the control chip as a general purpose chip. Specifically, the control chip is constructed of one chip microcomputer to effect the data transfer between the two memory chips DRAM and the FLASH. This makes the data transfer possible equivalently as in the embodiment of Fig. 1. Specifically, the data transfer is carried out by a special purpose local processor in place of the microprocessor on the system.

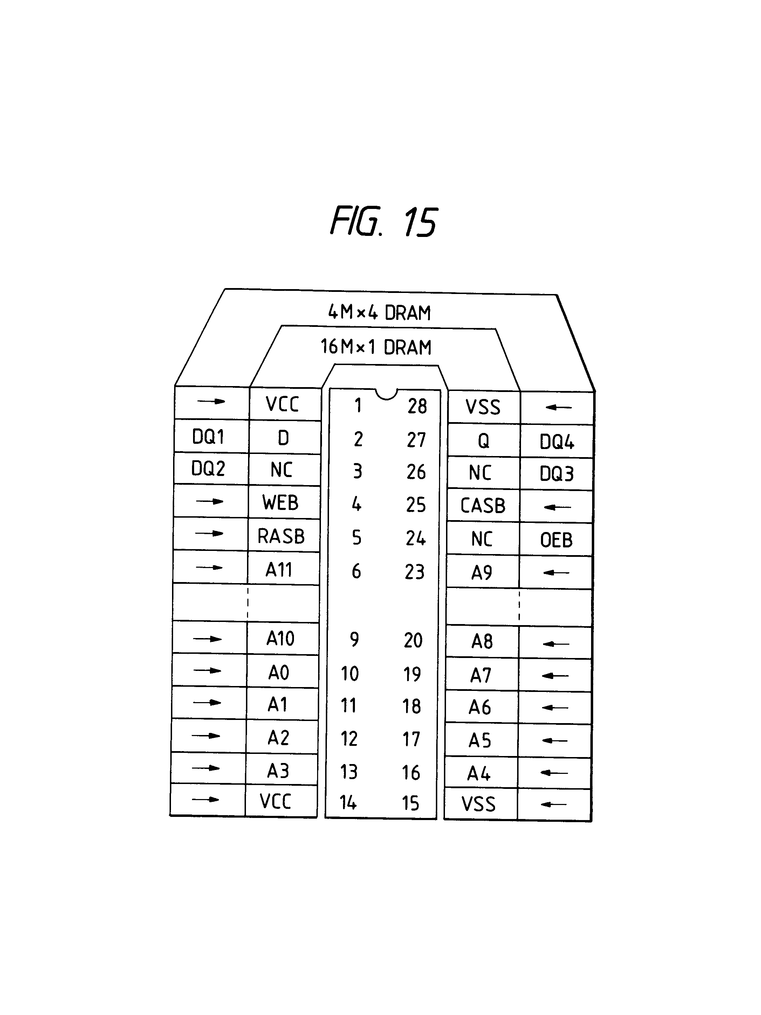

Fig. 15 is a diagram illustrating the pin arrangement of one embodiment of the DRAM. In this embodiment, the DRAM is given a storage capacity of about 16 Mbits and is constructed of a package of 28 pins. In this case, there are shown examples of a construction of x 1 bit and a construction of x 4 bits. For a construction of x 8 bits, the most significant bit address A10 is invalidated for the X- or Y-line.

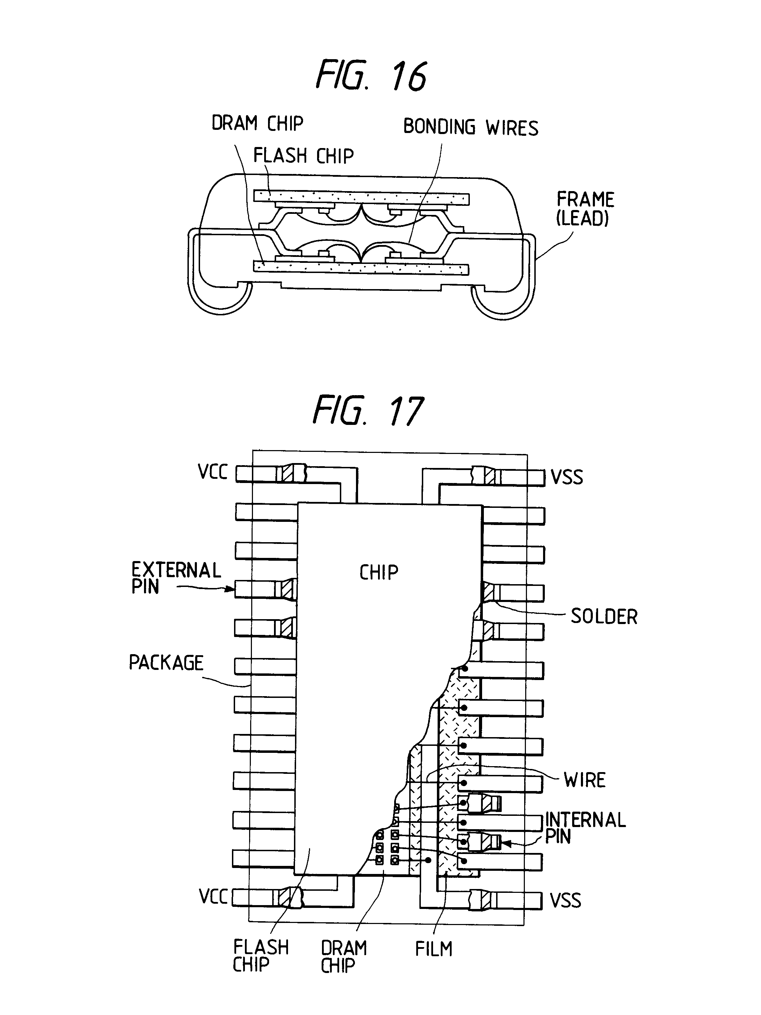

Fig. 16 is a section showing one embodiment of the semiconductor memory device according to the present invention.

In this embodiment, the frame (or lead) and the chip surface are adhered through films by an adhesive. The frame has its terminals connected with chip bonding pads through gold wires. In place of this construction, the frame may be connected by an adhesive to an insulator formed on the surface of the chip. Alternatively, the frame may be formed of a molding resin to cover the lead surface excepting the portion to be connected for the bonding and may be adhered and connected with the chip surface. The frame (or lead) has its terminals connected with the bonding pad of the chip by the gold wires.

In this embodiment, the frame is constructed such that its main frame integrated with the external terminals is connected with the DRAM chip. On the other hand, the Flash chip is connected with the frame called the auxiliary frame such that its surface lies over the aforementioned DRAM chip in a facing manner. As a result, the package is more or less thickened but can make the exterior shape of he semiconductor memory device substantially identical to that having one chip although the two chips are packaged.

Fig. 17 is a top plan view partially showing the inside of the semiconductor memory device shown in Fig. 16. Fig. 17 shows the upper Flash chip and a portion of the DRAM chip lying below the former, by way of example. Although not especially limitative, the frame or the internal pin of the Flash chip is soldered and electrically connected with the frame which is connected with the DRAM chip. In order to suppress the power supply impedance, the DRAM and the Flash in this embodiment are constructed such that the leads at the earth potential VSS are extended upward at the righthand side of the central portion of the chip, as elongated in Fig. 17, and connected by gold wires with the bonding pads for applying the earth potential to the DRAM chip and the Flash chip at a plurality of portions. Likewise, the leads at the powersupply voltage VCC such as 5 V are extended at the lefthand side of the central portion of the chip and are connected by the gold wires with the bonding pads for applying the power supply voltage to the DRAM chip and the Flash chip at a plurality of portions.

The film plays a role as an insulating film to prevent the surface of the aforementioned chip and the leads from electrically contacting with each other. In case, on the other hand, the three chips are sealed in one package as in the foregoing embodiment of Fig. 14, the control chip may likewise lie over the Flash chip or below the DRAM chip.

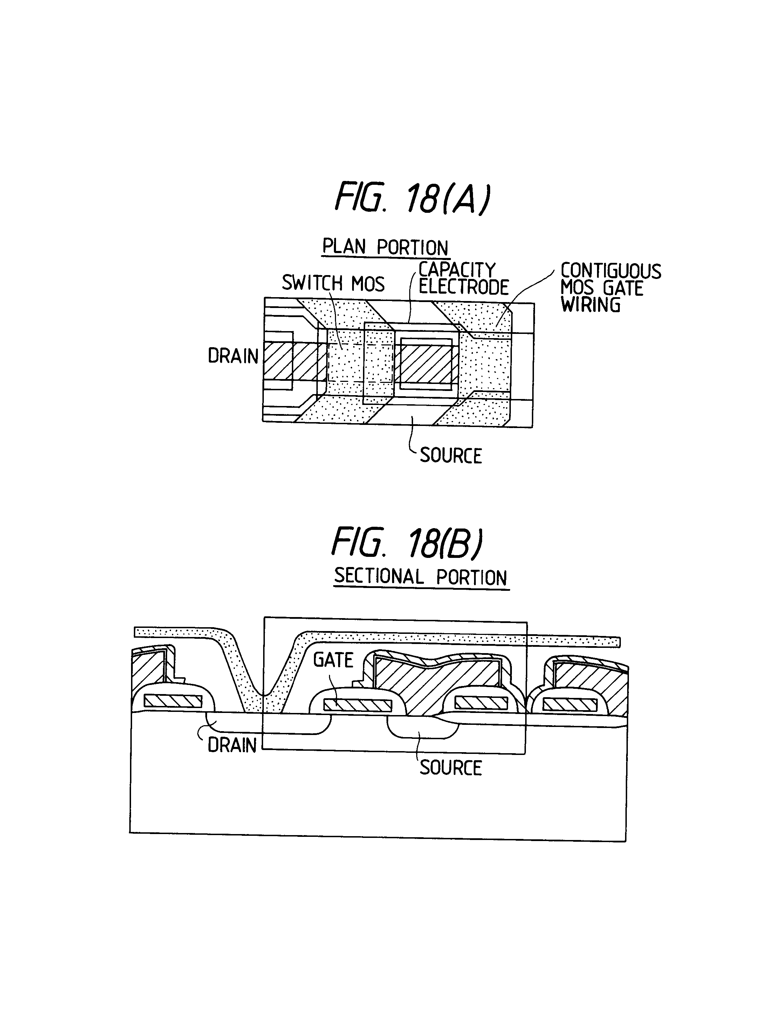

Fig. 18(A) is a top plan view showing a portion of one embodiment of the memory cell of the DRAM memory, and Fig. 18(B) is a section showing a corresponding portion. The memory cell of the DRAM memory is constructed to include a capacitor made of a data storing capacity electrode and an address selecting switch MOS.

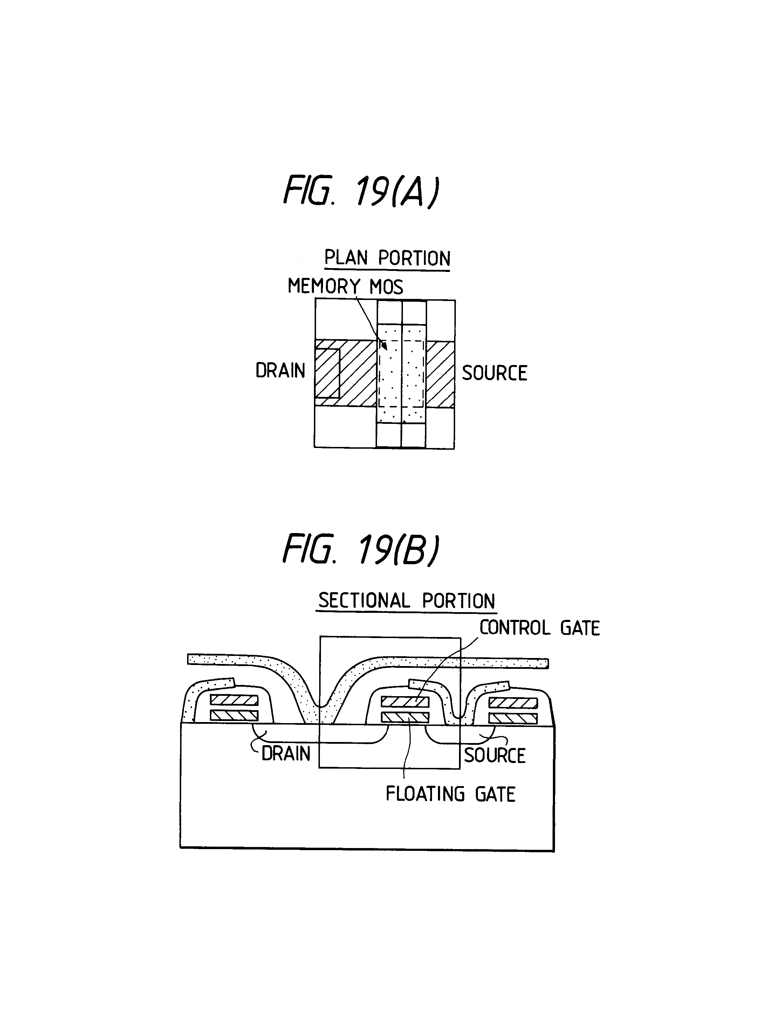

Fig. 19(A) is a top plan view showing a portion of one embodiment of the memory cell of the FLASH memory, and Fig. 19(B) is a section showing a corresponding portion. The memory cell of the FLASH memory is constructed of one memory MOS having a stacked gate structure composed of a source, a drain, and a floating gate and a control gate over a channel region formed between the source and the drain.

Figs. 18 and 19 are drawn in a substantially equal scale. Thus, the memory cell of the FLASH has a slightly smaller size than that of the memory cell of the DRAM. As in the embodiment of Fig. 21, however, the scale of the peripheral circuits is larger than that of the DRAM because of the writing operation and the erasing operation. Thanks to the relation in size between the memory cell array and its peripheral circuits, the DRAM chip and the FLASH chip having equal storage capacities can be made with substantially identical sizes.

It is extremely convenient for superposing and packaging the two memory chips, as in the embodiment of Fig. 16, that the two kinds of memory chips having equal storage capacities as above can be made to have substantially identical sizes.

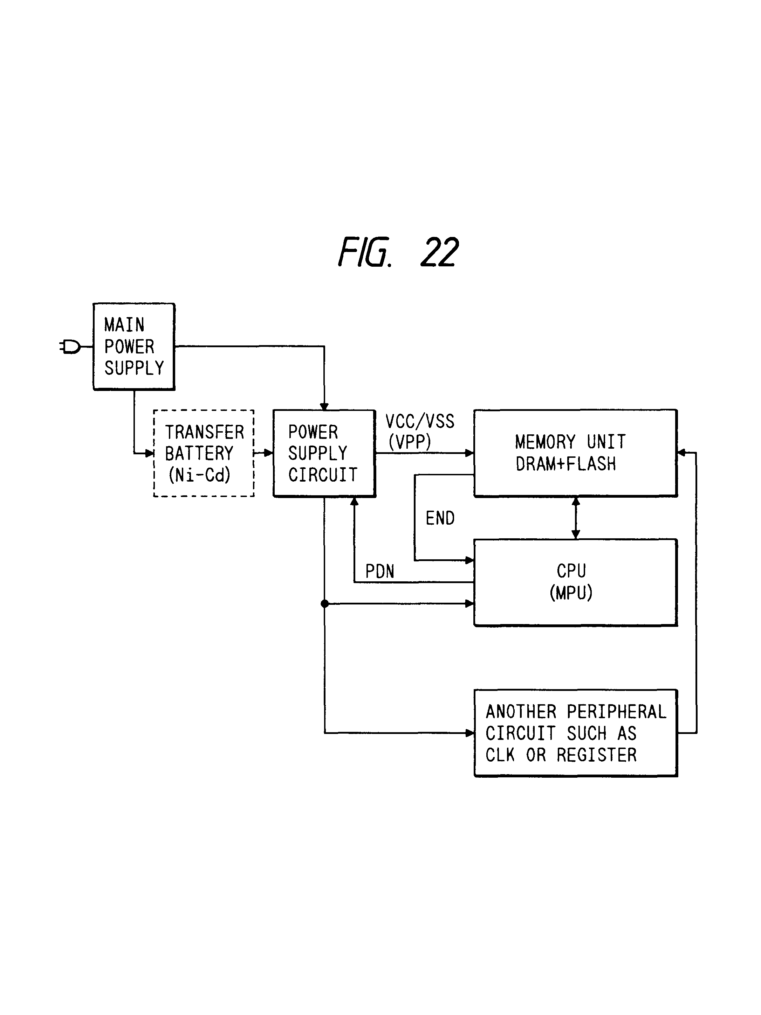

Fig. 22 is a block diagram showing one embodiment of a power supply method of a microcomputer system using the semiconductor memory device according to the present invention.

The power supply circuit receives the powerfrom the main power supply and supplies the voltages VCC, VSS and VPP to the memory unit (DRAM + FLASH) using the semiconductor memory device according to the present invention. Although not especially limitative, in the system having a transfer battery mounted therein, the power supply circuit can be operated by the transfer battery, when the main power supply is disconnected, to supply the power to the internal circuit.

If the aforementioned system is equipped with the transfer battery having a relatively small capacity so that the FLASH cannot be rewritten, the battery is used to bring the DRAM into the self-refresh mode thereby to use the same as a battery backup. In other words, the data can be prevented from being broken even when the power supply is accidentally disconnected.

If the aforementioned transferring battery has a large capacity, it continues the power supply to the CPU and the memory unit, even when the main power supply is accidentally or undesirably disconnected, to produce a power-down signal PDN for the CPU to interrupt the operation of the power supply circuit in response to a transfer ending signal END after the data of the DRAM has been transferred to the FLASH.

In a normal power supply disconnection, it is confirmed that the CPU has accessed the DRAM and FLASH of the memory unit or has instructed the transfer command to the memory unit to transfer the data of the DRAM to the FLASH. After this confirmation, the main power supply is disconnected. The number of rewriting the FLASH is limited to about one hundred thousands by that operation. However, this limit to the rewriting number can be eliminated by combining the FLASH with the DRAM as above so that the ordinary data rewrite may be accomplished upon the DRAM while causing the FLASH to be rewritten only when the power supply is disconnected. Specifically, if the power supply of the aforementioned microcomputer system is disconnected two times a day, it can be used for 10 years or more by the calculation of 100,000/365x2 = 100 years even if the limit to the rewriting number is ten thousands. Since, moreover, the data rewrite in the data processing is accomplished upon the DRAM, the memory access can be highly accelerated to shorten the data processing time period drastically.

The operational effects to be obtained from the embodiments described above are as follows:
(1) One semiconductor memory device is constructed by packaging the nonvolatile memory chip capable of being electrically written and erased and a RAM into a common package, so that an ordinary memory access is accomplished upon the RAM. As a result, the operation can be accelerated while eliminating the limit to the number of rewriting the nonvolatile memory. In addition, the data can be made nonvolatile because the data of the RAM are transferred to the nonvolatile memory because the power supply is disconnected.
(2) The aforementioned nonvolatile memory chip used is exemplified by the batch-erasure type nonvolatile memory in which the data charge stored in the floating gate is erased through the tunnel current flowing through the tunnel oxide film, and the RAM used is exemplified by the dynamic RAM so that the two memories can have substantially identical chip sizes and equal storage capacities. This raises another effect that the two memory chips can be combined into one in excellent compatibility.
(3) The aforementioned nonvolatile memory chip and RAM chip are equipped with the substantially identical external address terminals and control terminals, which are commonly fed with the address signals and the control signals from the outside, and with the control terminals for selecting which chip is to be accessed. This raises still another effect that the corresponding terminals in the package can be easily connected.
(4) Into the aforementioned nonvolatile memory chip, there are incorporated the control circuits for controlling a series of automatic erasing operations and automatic writing operations. Afurther effect is that the rewrite can be easily accomplished from the outside.
(5) Into the aforementioned nonvolatile memory chip and RAM chip, there are incorporated the control circuits for causing the data to be transferred inbetween so that what is done from the outside is to instruct the data transfer. A further effect is that the handling can be remarkably simplified.
(6) The aforementioned nonvolatile memory chip cannot be directly accessed from the outside. A further effect is that the memory control can be simplified.
(7) The aforementioned nonvolatile memory chip and RAM chip are packaged by the LOC technique such that they are connected with the lead frame and are superposed and connected electrically through the leads in the common package. A further effect is that the substantial size of the semiconductor memory device can be reduced.
(8) A common package is constructed by packaging the nonvolatile memory chip capable of being electrically written and erased, the RAM chip, and the control chip for the data transfer between the two foregoing memory chips, into the common package. Afurther effect is that a semiconductor memory device having a new function can be manufactured by using the general purpose chip.

Our invention has been specifically described in connection with the embodiments thereof. However, the invention should not be limited to the foregoing embodiments but can naturally be modified in various manners without departing from the gist thereof. For example, the RAM used may be not only the dynamic RAM but also a static RAM. The nonvolatile memory capable of being electrically erased may be exemplified not only by the FLASH but also by a FLTOX type MNOS transistor making use of the tunnel current for the writing operation, too.

In case the dynamic RAM is used, the address terminals may input the X- and Y-addresses from independent terminals. In case the address terminals are thus made independent, the nonvolatile memory such as the FLASH may be accordingly equipped with independent address terminals. When the two chips are superposed and mounted in one package, they may be arranged back-to-back, as contrary to the arrangement of Fig. 16, such that the auxiliary frame has its leads extended backward and connected with the corresponding leads of the main frame. In these ways, the construction of packaging the two or three chips into one package may take a variety of modes of embodiment.

The present invention can be widely applied to a semiconductor memory device having a RAM chip and a nonvolatile memory chip combined therein.

The effects to be attained by the representative of the invention disclosed herein will be briefly described in the following. One semiconductor memory device is constructed by packaging the nonvolatile memory chip capable of being electrically written and erased and a RAM into a common package, so that an ordinary memory access is accomplished upon the RAM. As a result, the operation can be accelerated while eliminating the limit to the number of rewriting the nonvolatile memory. In addition, the data can be made nonvolatile because the data of the RAM are transferred to the nonvolatile memory because the power supply is disconnected.

## Claims

1. A semiconductor memory device to be packaged in one package, comprising:
a volatile memory formed on one semiconductor substrate and including a plurality of first memory cells, wherein each of said first memory cells has one MOSFET and one capacitor; and
a nonvolatile memory formed on one semiconductor substrate and including a plurality of second memory cells, wherein each of said second memory cells has a source, a drain, and a floating gate and a control gate over a channel region formed between said source and said drain.

2. A semiconductor memory device according to claim 1, wherein each of said volatile memory and said nonvolatile memory has an equal number of memory cells.

3. A semiconductor memory device according to claim 2, wherein each of said volatile memory and said nonvolatile memory is fed with a mode selecting signal so that. said volatile memory is accessed when said mode selecting signal is at a first level and so that said nonvolatile memory is accessed when said mode selecting signal is at a second level.

4. A semiconductor memory device according to claim 3, wherein the data read out from said volatile memory when said mode selecting signal takes said first level are stored in said nonvolatile memory by setting said mode selecting signal to said second level.

5. A semiconductor memory device according to claim 3, wherein the data read out from said nonvolatile memory when said mode selecting signal takes said second level are stored in said nonvolatile memory by setting said mode selecting signal to said first level.

6. A semiconductor memory device according to claim 4, wherein each of said volatile memory and said nonvolatile memory further includes a plurality of address terminals coupled to a plurality of address terminals of said package.

7. A semiconductor memory device according to claim 5, wherein each of said volatile memory and said nonvolatile memory further includes a plurality of address terminals coupled to a plurality of address terminals of said package.

8. A semiconductor memory device according to claim 2, wherein said volatile memory further includes a plurality of address terminals coupled to a plurality of address terminals of said package.

9. A semiconductor memory device according to claim 8, wherein each of said volatile memory and said nonvolatile memory is fed with a transfer direction instructing signal so that a data transfer is executed between said volatile memory and outside of said package when said transfer direction instructing signal is at a first level and so that a data transfer is executed between said volatile memory and said nonvolatile memory when said transfer direction instructing signal is at a second level.

10. A semiconductor memory device according to claim 9, wherein said nonvolatile memory further includes first control means for feeding a first control signal to said volatile memory, and wherein volatile memory further includes second control means for feeding a second control signal to said nonvolatile memory.

11. A semiconductor memory device according to claim 10, wherein data stored in said nonvolatile memory are read, if fed with said second control signal, when said transfer direction indicating signal is at said second level, and wherein said volatile memory stores said read-out data if fed with said first control signal when said transfer direction indicating signal is at said second level.

12. A semiconductor memory device according to claim 10, wherein data stored in said volatile memory are read, if fed with said first control signal, when said transfer direction indicating signal is at said second level, and wherein said nonvolatile memory stored said read-out data if fed with said second control signal when said transfer direction indicating signal is at said second level.

13. A microcomputer system comprising a CPU, and a memory device to be packaged in one package, said memory device comprising:
a volatile memory formed on one semiconductor substrate and including a plurality of first memory cells, wherein each of said first memory cells has one MOSFET and one capacitor; and
a nonvolatile memory formed on one semiconductor substrate and including a plurality of second memory cells, wherein each of said second memory cells has a source, a drain, and a floating gate and a control gate over channel region formed between said source and said drain.

14. A microcomputer system according to claim 13, further comprising control means for producing a mode selecting signal based on a control signal from said CPU.

15. A microcomputer system according to claim 14, wherein each of said volatile memory and said nonvolatile memory has an equal number of memory cells.

16. A microcomputer system according to claim 15, wherein each of said volatile memory and said nonvolatile memory is fed with a mode selecting signal so that said volatile memory is accessed when said mode selecting signal is at a first level and so that said nonvolatile memory is accessed when said mode selecting signal is at a second level.

17. A microcomputer system according to claim 16, wherein the data stored in said nonvolatile memory are read when said mode selecting signal takes said first level and wherein said read out data are stored in said volatile memory when said mode selecting signal takes said second level.

18. A microcomputer system according to claim 16, wherein the data read out from said volatile memory when said mode selecting signal takes said second level are stored in said nonvolatile memory by setting said mode selecting signal to said first level.

19. A microcomputer system according to claim 17, wherein each of said volatile memory and said nonvolatile memory further includes a plurality of address terminals coupled to a plurality of address terminals of said package.

20. A microcomputer system according to claim 18, wherein each of said volatile memory and said nonvolatile memory further includes a plurality of address terminals coupled to a plurality of address terminals of said package.

21. A microcomputer system according to claim 15, wherein said volatile memory further includes a plurality of address terminals coupled to a plurality of address terminals of said package.

22. A microcomputer system according to claim 21, wherein each of said volatile memory and said nonvolatile memory is fed with a transfer direction instructing signal so that a data transfer is executed between said volatile memory and outside of said package when said transfer direction instructing signal is at a first level and so that a data transfer is executed between said volatile memory and said nonvolatile memory when said transfer direction instructing signal is at a second level.

23. A microcomputer system according to claim 22, wherein said nonvolatile memory further includes first control means for feeding a first control signal to said volatile memory, and wherein volatile memory further includes second control means for feeding a second control signal to said nonvolatile memory.

24. A microcomputer system according to claim 23, wherein data stored in said nonvolatile memory are read, if fed with said second control signal, when said transfer direction indicating signal is at said second level, and wherein said volatile memory stores said read-out data if fed with said first control signal when said transfer direction indicating signal is at said second level.

25. A microcomputer system according to claim 23, wherein data stored in said nonvolatile memory are read, if fed with said first control signal, when said transfer direction indicating signal is at said second level, and wherein said nonvolatile memory stored said read-out data if fed with said second control signal when said transfer direction indicating signal is at said second level.
